(19) Europäisches Patentamt
European Patent Office
Office européen des brevets

(11) EP 4 712 710 A1

(12) **EUROPEAN PATENT APPLICATION**
published in accordance with Art. 153(4) EPC

(43) Date of publication:
**18.03.2026 Bulletin 2026/12**

(21) Application number: **24814512.0**

(22) Date of filing: **29.05.2024**

(51) International Patent Classification (IPC):
***H05K 7/20*** *(2006.01)*

(86) International application number:
**PCT/CN2024/096200**

(87) International publication number:
**WO 2024/245315 (05.12.2024 Gazette 2024/49)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **30.05.2023 CN 202310631049**

(71) Applicant: **Huawei Technologies Co., Ltd.**
**Shenzhen, Guangdong 518129 (CN)**

(72) Inventors:
- **TIAN, Xiangyu**
  **Shenzhen, Guangdong 518129 (CN)**
- **FANG, Haoming**
  **Shenzhen, Guangdong 518129 (CN)**
- **JIN, Linfang**
  **Shenzhen, Guangdong 518129 (CN)**
- **WANG, Yingxian**
  **Shenzhen, Guangdong 518129 (CN)**

(74) Representative: **Epping - Hermann - Fischer Patentanwaltsgesellschaft mbH**
**Schloßschmidstraße 5**
**80639 München (DE)**

(54) **WORKING SUBSTANCE, LIQUID COOLING MODULE, ELECTRONIC DEVICE, AND PREPARATION METHOD FOR WORKING SUBSTANCE**

(57) This application discloses a working substance, a liquid cooling module, an electronic device, and a method for preparing a working substance, and relates to the field of electronic device technologies. The working substance may include a first medium and a second medium, where a liquid-liquid interface exists between the second medium and the first medium, and a heat dissipation coefficient of the first medium is greater than a heat dissipation coefficient of the second medium. The heat dissipation coefficient of the first medium is greater than the heat dissipation coefficient of the second medium, and the first medium has the larger heat dissipation coefficient, so that the working substance including the first medium has good heat dissipation performance. The liquid-liquid interface exists between the second medium and the first medium. In a moving process of the working substance, the liquid-liquid interface moves relative to a cavity configured to accommodate the working substance, to achieve significant flowing visualization effect. The working substance disclosed in this application may be used in the electronic device, so that at least a partial region of the electronic device has flowing visualization effect.

[FIG. 3]

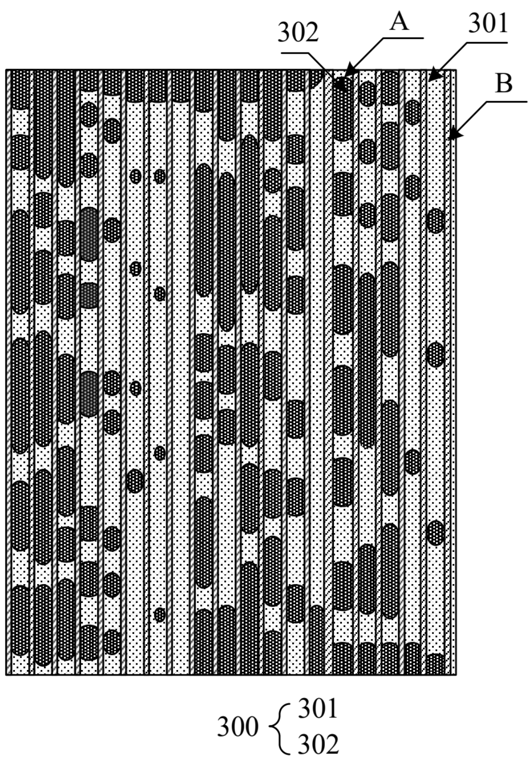


EP 4 712 710 A1

## Description

This application claims priorities to Chinese Patent Application No. 202310631049.6, filed with the China National Intellectual Property Administration on May 30, 2023, and entitled "WORKING SUBSTANCE, LIQUID COOLING MODULE, ELECTRONIC DEVICE, AND METHOD FOR PREPARING WORKING SUBSTANCE", and to Chinese Patent Application No. 202410687709.7, filed with the China National Intellectual Property Administration on May 29, 2024, and entitled "WORKING SUBSTANCE, LIQUID COOLING MODULE, ELECTRONIC DEVICE, AND METHOD FOR PREPARING WORKING SUBSTANCE", both of which are incorporated herein by reference in their entireties.

## TECHNICAL FIELD

This application relates to the field of electronic device technologies, and in particular, to a working substance, a liquid cooling module, an electronic device, and a method for preparing a working substance.

## BACKGROUND

A liquid cooling module may include a pump and a working substance. The working substance (working substance) may be understood as a carrier for mutual conversion between thermal energy and mechanical energy. The pump may be used as a power source of the working substance to provide power for flowing of the working substance. In a flowing process, the working substance may be used as a carrier for heat transfer, so that the liquid cooling module can achieve heat dissipation.

In recent years, flowing of the working substance may be visualized, to achieve a flowing display region with a sense of science and technology. A working substance with a visible flowing state disclosed in a related technology includes water and a dye. The dye may color the working substance, so that a flowing process of the working substance can present flowing visualization effect.

The colored working substance may present the flowing visualization effect in a liquid cooling module with a large size, but a size of a liquid cooling module used in an electronic device is small (a cavity size of the liquid cooling module is usually on a microliter-scale). As a result, the working substance disclosed in the related technology in the electronic device has poor flowing visualization effect.

## SUMMARY

This application discloses a working substance, a liquid cooling module, an electronic device, and a method for preparing a working substance. The working substance may include a first medium and a second medium. A liquid-liquid interface exists between the first medium and the second medium. When the working substance moves, the liquid-liquid interface moves relative to a cavity configured to accommodate the working substance, to generate significant flowing visualization effect.

A first aspect of this application discloses a working substance, including a first medium and a second medium. A liquid-liquid interface exists between the first medium and the second medium, and a heat dissipation coefficient of the first medium is greater than a heat dissipation coefficient of the second medium.

In this implementation, the working substance may include the first medium and the second medium. The liquid-liquid interface exists between the second medium and the first medium. The heat dissipation coefficient of the first medium is greater than the heat dissipation coefficient of the second medium, so that the working substance including the first medium has good heat dissipation performance. The liquid-liquid interface exists between the second medium and the first medium. In a moving process of the working substance, the liquid-liquid interface moves relative to an inner wall of a cavity, to achieve significant flowing visualization effect. The working substance disclosed in this application may be used in an electronic device, so that at least a partial region of the electronic device has flowing visualization effect.

With reference to the first implementation of the first aspect, the working substance further includes a first additive, where the first additive is used to reduce surface tension of the first medium.

In this implementation, the working substance may include the first additive, and the first additive is used to reduce the surface tension of the first medium. The first additive can improve infiltration performance of the working substance to the cavity, and reduce a problem of wall hanging of the first medium (working substance).

With reference to the second implementation of the first aspect, the first additive includes at least one of a fluorocarbon surfactant, a polyoxyethylene ether nonionic surfactant, and a gemini surfactant.

In this implementation, the first additive includes the at least one of the fluorocarbon surfactant, the polyoxyethylene ether nonionic surfactant, and the gemini surfactant. The first additive includes a hydrophilic group and a hydrophobic group. The hydrophilic group of the first additive may be in contact with the first medium, so that the hydrophobic group of the first additive faces a direction away from the first medium. In other words, the hydrophobic group

wraps the first medium. The hydrophobic group is in contact with the inner wall of the cavity when the working substance flows/is injected into the cavity, and the hydrophobic group has good infiltration performance to the cavity, thereby improving infiltration of the working substance to the inner wall of the cavity, and alleviating a problem of wall hanging of the working substance.

With reference to the third implementation of the first aspect, a molecular structural formula of the fluorocarbon surfactant may include:

$$F(CF_2)_xCH_2CH_2O(CH_2CH_2O)_y.$$

In $F(CF_2)_xCH_2CH_2O(CH_2CH_2O)_y$, x=6, and y ranges from 5 to 14.

In this implementation, in $F(CF_2)_xCH_2CH_2O(CH_2CH_2O)_y$, a group including a fluorocarbon bond (C-F) may be used as the hydrophobic group, and an aldehyde group

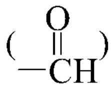

may be used as the hydrophilic group, so that the fluorocarbon surfactant whose molecular structure includes $F(CF_2)_xCH_2CH_2O(CH_2CH_2O)_y$ can reduce the surface tension of the first medium, thereby alleviating the problem of wall hanging of the working substance.

With reference to the fourth implementation of the first aspect, a molecular structural formula of the polyoxyethylene ether nonionic surfactant may include:

at least one of $RO(CH_2CH_2O)_nH$ and

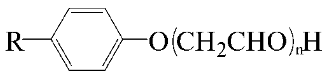 ,

where R in $RO(CH_2CH_2O)_nH$ and

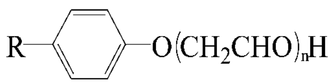

includes a hydrophobic group or a hydrogen atom.

In this implementation, in $RO(CH_2CH_2O)_nH$ and

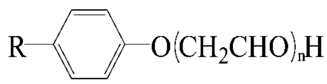

, R may be used as the hydrophobic group, and an ether bond (-O-) may be used as the hydrophilic group, so that the polyoxyethylene ether nonionic surfactant (the first additive) whose molecular structure includes $RO(CH_2CH_2O)_nH$ and

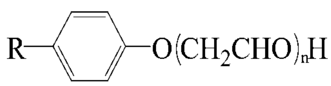

can reduce the surface tension of the first medium, thereby alleviating the problem of wall hanging of the working substance.

With reference to the fifth implementation of the first aspect, a molecular structural formula of the gemini surfactant includes

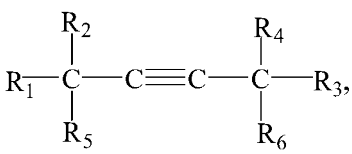,

where at least one of $R_1$, $R_2$, $R_3$, $R_4$, $R_5$, and $R_6$ is a hydrophilic group, and at least one of $R_1$, $R_2$, $R_3$, $R_4$, $R_5$, and $R_6$ is a

hydrophobic group.

A molecule of the gemini surfactant disclosed in this implementation includes the hydrophilic group and the hydrophobic group. In the working substance, the hydrophilic group of the gemini surfactant may be dissolved in the first medium, so that the hydrophobic group of the gemini surfactant faces away from the first medium. In a flow process, the hydrophobic group exists between the first medium and the inner wall of the cavity, to reduce the surface tension of the first medium and improve the infiltration performance of the first medium to the inner wall of the cavity, thereby alleviating the problem of wall hanging of the first medium.

With reference to the sixth implementation of the first aspect, each of $R_1$ , $R_2$, $R_3$, and $R_4$ includes the hydrophobic group, and each of $R_5$ and $R_6$ includes the hydrophilic group.

In the molecular structure of the gemini surfactant disclosed in this implementation, each of $R_1$ , $R_2$, $R_3$, and $R_4$ includes the hydrophobic group, and each of $R_5$ and $R_6$ includes the hydrophilic group. The gemini surfactant has good symmetry, so that the gemini surfactant has high rigidity. In a flowing process, the gemini surfactant can quickly reach between the first medium and the inner wall of the cavity, to reduce surface tension of the first medium and suppress wall hanging of the first medium.

With reference to the seventh implementation of the first aspect, a mass fraction of the first additive in the working substance ranges from 0.01% to 20%.

When the mass fraction of the first additive in the working substance is greater than or equal to 0.01%, the working substance may have good infiltration performance to the inner wall of the cavity, thereby alleviating the problem of wall hanging of the working substance.

When the mass fraction of the first additive in the working substance is less than or equal to 20%, the mass fraction of the first medium in the working substance is large, and correspondingly, the working substance has good heat dissipation performance.

When the mass fraction of the first additive in the working substance ranges from 0.01% to 20%, the working substance can have both the heat dissipation performance and the infiltration performance to the inner wall of the cavity.

With reference to the eighth implementation of the first aspect, the working substance further includes a second additive, where the second additive is configured to break an emulsion.

In this implementation, the working substance includes the second additive, and the second additive is configured to break the emulsion. When the second medium is dispersed in the first additive in a form of small droplet to form the emulsion, under an action of the second additive, the second medium dispersed in the form of small droplet aggregates to form the second medium in a continuous phase, to restore the liquid-liquid interface between the first medium and the second medium, so that the working substance restores the flowing visualization effect.

With reference to the ninth implementation of the first aspect, the second additive includes at least one of an organic alcohol compound, an organic ketone compound, an organic acid compound, a lipid organic compound, an ether organic compound, an aromatic compound, and an organic salt.

In this implementation, the second additive includes at least one of the organic alcohol compound, the organic ketone compound, the organic acid compound, the lipid organic compound, the ether organic compound, the aromatic compound, and silicone oil. A bonding capability between the second additive and the first medium is stronger than a bonding capability between the second medium and the first medium. After the first medium and the second medium are emulsified, the first medium is preferably bonded with the second additive. In this way, a thickness of a hydrated layer on a surface of the small droplet is decreased, and the second medium existing in the form of small droplet tends to aggregate to form the second medium existing in the continuous phase form (the liquid-liquid interface exists between the second medium existing in the continuous phase form and the first medium), so as to restore the liquid-liquid interface between the first medium and the second medium, thereby achieving demulsification effect.

With reference to the tenth implementation of the first aspect, a molecular structural formula of silicone oil includes

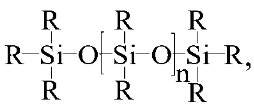,

where R includes at least one of methyl, methoxy, ethyl, ethoxy, propyl, butyl, pentyl, hexyl, heptyl, octyl, phenyl, hydroxyl, and vinyl, and a side chain of R is preferably a $C_3$-$C_{18}$ alkyl substituent.

In this implementation,

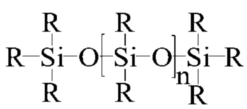

includes a hydrophilic group silicon-oxygen bond (-Si-O). In addition, R includes H, methyl, methoxy, ethyl, ethoxy, propyl, butyl, pentyl, hexyl, heptyl, octyl, phenyl, hydroxyl, vinyl, and the like, and the side chain of R is preferably the $C_3$-$C_{18}$ alkyl substituent, so that the bonding capability between

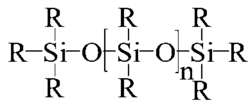

and the first medium is stronger than the bonding capability between the second medium and the first medium. After the first medium and the second medium are emulsified, the first medium is preferably bonded with

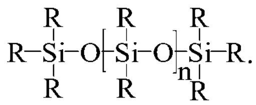

In this way, the thickness of the hydrated layer on the surface of the small droplet is decreased, and the second medium existing in the form of small droplet tends to aggregate to form the second medium existing in the continuous phase form, so as to restore the liquid-liquid interface between the first medium and the second medium, thereby achieving the demulsification effect.

With reference to the eleventh implementation of the first aspect, n in

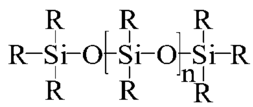

ranges from 0 to 100.

When n

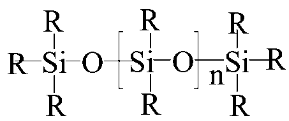

in is greater than or equal to 0,

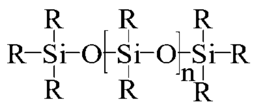

has a high thermal stability, so that the working substance including

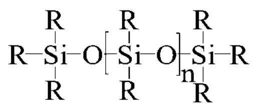

has a good thermal stability.

When n in

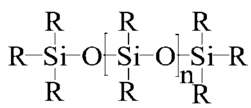

is less than or equal to 100,

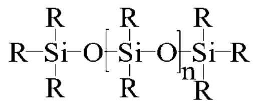

has a high rigidity, so that the working substance including the second additive can quickly restore the liquid-liquid interface after being emulsified, that is, the working substance has a stable liquid-liquid interface.

When n in

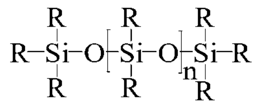

ranges from 0 to 100, the working substance has both the high thermal stability and the stable liquid-liquid interface.

With reference to the twelfth implementation of the first aspect, a molecular structural formula of the second medium includes:

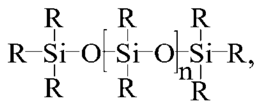

where R includes at least one of methyl, methoxy, ethyl, ethoxy, propyl, butyl, pentyl, hexyl, heptyl, octyl, phenyl, hydroxyl, and vinyl.

In this implementation, in

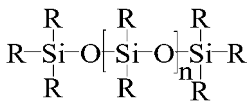 , 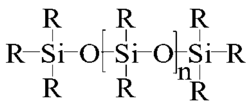

disclosed in this implementation may be used as the second medium to form the liquid-liquid interface with the first medium.

With reference to the thirteenth implementation of the first aspect, a mass fraction of the second additive in the working substance ranges from 0.01% to 20%.

When the mass fraction of the second additive in the working substance is greater than or equal to 0.01%, the emulsified working substance can quickly restore the liquid-liquid interface, that is, the working substance can have a stable liquid-liquid interface.

When the mass fraction of the second additive in the working substance is less than or equal to 20%, the mass fraction of the first medium in the working substance is large, and correspondingly, the working substance has good heat dissipation performance.

When the mass fraction of the second additive in the working substance ranges from 0.01% to 20%, the working substance can have both the heat dissipation performance and the flowing visualization performance.

With reference to the fourteenth implementation of the first aspect, the working substance further includes a water-soluble dye, where a solubility of the water-soluble dye in the first medium is greater than a solubility of the water-soluble dye in the second medium.

In this implementation, the working substance includes the water-soluble dye. The solubility of the water-soluble dye in the first medium is greater than the solubility of the water-soluble dye in the second medium, and the water-soluble dye can be dissolved in the first medium, so that the first medium is colored. Introduction of the water-soluble dye may make the first medium and the second medium have a large color contrast, so that the working substance can have significant flowing visualization effect.

With reference to the fifteenth implementation of the first aspect, the working substance further includes an oil-soluble dye, where a solubility of the oil-soluble dye in the second medium is greater than a solubility of the oil-soluble dye in the first medium.

In this implementation, the working substance includes the oil-soluble dye. The solubility of the oil-soluble dye in the second medium is greater than the solubility of the oil-soluble dye in the first medium, and the oil-soluble dye can be dissolved in the second medium. Introduction of the oil-soluble dye for coloring the second medium may make the second medium and the first medium have a large color contrast, so that the working substance can have significant flowing visualization effect.

It should be noted that, in the implementation in which the working substance includes the water-soluble dye and the oil-soluble dye, the oil-soluble dye and the water-soluble dye need to have different colors, so that the second medium and the first medium have a large color contrast. For example, a red water-soluble dye and a blue oil-soluble dye may be selected.

With reference to the sixteenth implementation of the first aspect, the first medium includes at least one of water and a liquid metal.

In this implementation, the first medium includes at least one of the water ($H_2O$) and the liquid metal. $H_2O$ and the liquid metal have good heat dissipation performance. $H_2O$ and the liquid metal may be used as the first medium, so that the working substance can achieve good heat dissipation performance, and the working substance can be ensured to achieve good heat dissipation performance.

With reference to the seventeenth implementation of the first aspect, a mass fraction of the first medium in the working substance is greater than or equal to 50%.

In this implementation, the mass fraction of the first medium in the working substance is greater than or equal to 50%, that is, the working substance includes a large amount of first medium (the first medium has good heat dissipation performance), to ensure that the working substance can achieve good heat dissipation performance.

With reference to the eighteenth implementation of the first aspect, a conductivity of the first medium is less than or equal to 500 μs/cm.

In this implementation, the conductivity of the first medium is less than or equal to 500 μs/cm, and the first medium has a small conductivity, so that the working substance including the first medium has a small conductivity. When the working substance is used in the electronic device, the working substance may have small impact on an electromagnetic signal in the electronic device.

With reference to the nineteenth implementation of the first aspect, the second medium includes at least one of hydrocarbon, a heterocyclic organic compound, and a fluorinated liquid.

In this implementation, the second medium includes at least one of the hydrocarbon, the heterocyclic organic compound, and the fluorinated liquid. The second medium may form the liquid-liquid interface with the first medium, so that the working substance can move relative to the inner wall of the cavity in the flowing process, and the working substance presents flowing visualization effect.

With reference to the twentieth implementation of the first aspect, a mass fraction of the second medium in the working substance ranges from 0.1% to 50%.

When the mass fraction of the second medium in the working substance is greater than or equal to 0.1%, a size of the liquid-liquid interface formed by the second medium and the first medium is large, and correspondingly, the working substance presents more significant flowing visualization effect.

When the mass fraction of the second medium in the working substance is less than or equal to 50%, the mass fraction of the first medium in the working substance is large, and correspondingly, the working substance has good heat dissipation performance.

When the mass fraction of the second medium in the working substance ranges from 0.1% to 50%, the working substance can have both the heat dissipation performance and the infiltration performance to the inner wall of the cavity.

With reference to the twenty-first implementation of the first aspect, the working substance is used in an electronic device.

With reference to the twenty-second implementation of the first aspect, a viscosity of the second medium is less than or equal to 100 mPa·s.

In this implementation, in an environment of 25°C, the viscosity of the second medium is less than or equal to 100 mPa·s. The second medium has a low viscosity, so that the working substance has a low viscosity, resistance to the working substance is small in the flowing process, and the working substance can transfer a large amount of heat per unit time.

A second aspect of this application discloses a liquid cooling module, including the working substance disclosed in the first aspect and a pump. The pump is configured to drive the working substance to move, so that a liquid-liquid interface of the working substance moves relative to a cavity configured to accommodate the working substance.

The liquid cooling module disclosed in this implementation may include the pump and the working substance. The pump communicates with the working substance, and the pump is configured to drive the working substance to move. In a moving process of the working substance, the liquid-liquid interface formed by the first medium and the second medium moves relative to an inner wall of the cavity. In the moving process of the working substance, the liquid-liquid interface moves relative to the inner wall of the cavity, to achieve significant flowing visualization effect.

A third aspect of this application discloses an electronic device, including a housing and the liquid cooling module disclosed in the second aspect. The liquid cooling module is embedded into the housing, and visible light transmittance of at least a partial region of the housing covering the liquid cooling module is greater than or equal to a threshold.

In this implementation, the liquid cooling module may include a pump and a working substance. The working substance may include a first medium and a second medium. The pump is used as a power source of the working

substance to drive the working substance to move. In a moving process of the working substance, a liquid-liquid interface moves relative to an inner wall of a cavity, to achieve significant flowing visualization effect.

The liquid cooling module is embedded into the housing, and visible light transmittance of at least the partial region of the housing covering the liquid cooling module is greater than or equal to the threshold, so that the flowing visualization effect of the working substance can be displayed through the housing in the region. In other words, the electronic device may have flowing visualization effect.

With reference to the first implementation of the third aspect, the housing is provided with a groove, and the groove forms a cavity configured to accommodate the working substance.

With reference to the second implementation of the third aspect, the liquid cooling module further includes a liquid cooling component, and the liquid cooling component has a cavity configured to accommodate the working substance.

A fourth aspect of this application discloses an accessory, applicable to an electronic device, and including an accessory body and the liquid cooling module disclosed in the second aspect. The liquid cooling module is embedded into the accessory body, and visible light transmittance of at least a partial region of the accessory body covering the liquid cooling module is greater than or equal to a threshold.

In this implementation, the liquid cooling module may include a pump and a working substance. The working substance may include a first medium and a second medium. The pump is used as a power source of the working substance to drive the working substance to move. In a moving process of the working substance, a liquid-liquid interface moves relative to an inner wall of a cavity, to achieve significant flowing visualization effect.

The liquid cooling module is embedded into the accessory body, and visible light transmittance of at least the partial region of the accessory body covering the liquid cooling module is greater than or equal to the threshold, so that the flowing visualization effect of the working substance can be displayed through the accessory body in the region. In other words, the accessory may have flowing visualization effect.

A fifth aspect of this application discloses a method for preparing a working substance, including: measuring a first medium and a second medium; and mixing the first medium and the second medium to obtain the working substance disclosed in the first aspect. A heat dissipation coefficient of the first medium is greater than a heat dissipation coefficient of the second medium. In the working substance, a liquid-liquid interface exists between the first medium and the second medium.

For effect that can be achieved in the fifth aspect, refer to effect that can be achieved in any one of the feasible implementations of the first aspect.

## BRIEF DESCRIPTION OF DRAWINGS

FIG. 1 is a diagram of an electronic device;
FIG. 2 is an exploded view of a battery;
FIG. 3 is a diagram of a working substance (a cavity is filled with the working substance) disclosed in a feasible embodiment;
FIG. 4 is a diagram of a wall-hanging working substance (a cavity is filled with the working substance);
FIG. 5 is a diagram of an emulsified working substance (a cavity is filled with the working substance);
FIG. 6 is a diagram of a mobile phone disclosed in a feasible embodiment;
FIG. 7 is a diagram of a tablet computer disclosed in a feasible embodiment;
FIG. 8 is a diagram of a notebook computer disclosed in a feasible embodiment;
FIG. 9 is a diagram of a vehicle-mounted device disclosed in a feasible embodiment;
FIG. 10 is a sectional view of a flowing display region disclosed in a feasible embodiment;
FIG. 11 is a sectional view of a flowing display region disclosed in a feasible embodiment;
FIG. 12 is a diagram of a protective case disclosed in a feasible embodiment;
FIG. 13 is a diagram of assembly of a wearable device and a wrist strap disclosed in a feasible embodiment;
FIG. 14 is a diagram of assembly of a tablet computer and a protective case disclosed in a feasible embodiment; and
FIG. 15 is a diagram of assembly of a mobile phone and a connector disclosed in a feasible embodiment.

## DESCRIPTION OF EMBODIMENTS

The following describes technical solutions in embodiments of this application with reference to accompanying drawings in embodiments of this application. It is clear that the described embodiments are merely a part rather than all of embodiments of this application.

Terms "first", "second", and the like in this specification are merely intended for a purpose of description, and shall not be understood as an indication or implication of relative importance or implicit indication of a quantity of indicated

technical features. Therefore, a feature limited by "first" or "second" may explicitly or implicitly include one or more features. In the descriptions of this application, unless otherwise stated, "a plurality of" means two or more than two.

In addition, in this specification, position terms such as "top" and "bottom" are defined relative to positions of schematically placed structures in the accompanying drawings. It should be understood that these position terms are relative concepts used for relative description and clarification, and may correspondingly change based on changes in the positions of the structures.

Concepts in embodiments of this application are first described.

Conductivity (conductivity or electrical conductance): may be understood as a parameter for describing a degree of flowing difficulty of electric charge in a substance. Surface tension (surface tension): Liquid such as water generates a force for reducing a surface as much as possible. A wall hanging phenomenon of the liquid is related to surface tension of the liquid. Larger surface tension of the liquid indicates a more significant wall hanging phenomenon of the liquid.

Emulsification: means that a second medium is evenly dispersed in a first medium in a form of extremely small droplet.

Liquid-liquid interface: is an interface formed by contacting two or more immiscible or partially miscible liquids. In this patent, an area of the liquid-liquid interface is at least greater than or equal to 10 $\mu m^2$, and the liquid-liquid interface is visible to naked eyes. Technical effect brought by the liquid-liquid interface is that a flowing visualization state of a working substance can be observed to detect an operating state of a heat dissipation module and determine a temperature and heat dissipation performance of a device.

Demulsification: is a process in which a second medium changes from a small droplet state to a continuous phase state. A liquid-liquid interface may exist between the second medium existing in the continuous phase state and a first medium.

Demulsification efficiency: is a ratio of a mass or volume to time, where the time may be understood as time required for a second medium to change from a small droplet state to a continuous phase state.

Visible light (visible light): may be understood as a light wave with a wavelength of 380 nm to 760 nm.

Visible light transmittance (transmittance): is a ratio of radiant energy projected to and transmitted through an object to total radiant energy projected to the object.

Hydrophilic lipophilic balance (hydrophilic lipophilic balance, HLB): may be understood as a comprehensive affinity of a hydrophilic group and a hydrophobic group in a surfactant (additive) molecule to oil or water.

Hydrophilic group (hydrophilic group): may also be referred to as a polar group, and has an atomic group that is water-soluble or easily has an affinity to water.

Hydrophobic group (lipophilic group or oelophilic group): may also be referred to as a non-polar group, and is a group that has no affinity to water, is water-insoluble, or has an extremely low solubility.

Viscosity (viscosity): may be understood as presented resistance of a first medium to flowing. Specifically, in embodiments of this application, a lower viscosity of the first medium indicates smaller resistance to the first medium in a flowing process, more heat transferred by the first medium per unit time, and a more significant temperature conltrol function of a working substance. The viscosity of the first medium is affected by a temperature. Unless otherwise specified, the viscosity in embodiments of this application may be understood as a viscosity of the first medium at 25°C.

Mass fraction: may be understood as a mass ratio of a component (a first medium, a second medium, a first additive, or a second additive) to a working substance.

The following describes the solutions disclosed in embodiments of this application.

The electronic device in embodiments of this application may include but is not limited to electronic products such as a mobile phone, a tablet computer, a notebook computer, a wearable device, and a vehicle-mounted device.

Refer to FIG. 1. It can be seen that the electronic device includes a housing 20 and an electronic functional component (not shown in the figure) located in the housing 20. In embodiments of this application, the electronic device may be a foldable device or a bar-type device.

For example, refer to FIG. 1. A foldable mobile phone is used as an example to further describe the housing. The housing 20 may include a cavity configured to accommodate the electronic functional component (not shown in the figure). The housing 20 of the foldable mobile phone may include a first non-folding part 21 and a second non-folding part 22. The first non-folding part 21 and the second non-folding part 22 are connected through a folding part 23. The second non-folding part 22 can be folded toward the first non-folding part 21 through the folding part 23. The second non-folding part 22 is unfolded from the first non-folding part 21 through the folding part 23.

The electronic functional component in the electronic device 1 includes but is not limited to a processor, an internal memory, a charging management module, a power management module, a battery, an antenna, a communication module, a camera, an audio module, a loudspeaker, a receiver, a microphone, a sensor module, a motor, an indicator, and the like. The electronic device 1 may have more or fewer electronic functional components than those described above. Various electronic functional components may be implemented in hardware, software, or a combination of hardware and software including one or more signal processing and/or application-specific integrated circuits.

The electronic functional component releases heat in an operating state. When a temperature inside the

electronic device 1 is excessively high, operating efficiency of the electronic functional component and a service life of the electronic device 1 are affected. Therefore, a liquid cooling module 10 needs to be disposed, to perform temperature rise control on the electronic functional component.

Based on the foregoing considerations, in some feasible implementations, the liquid cooling module 10 is located between the housing 20 and the electronic functional component, to control a temperature of the electronic functional component. For example, still refer to FIG. 1. It can be seen that the liquid cooling module 10 is located on a side that is of the housing 20 and that is close to the electronic functional component. The liquid cooling module 10 may control a temperature of the electronic functional component.

In some feasible implementations, the liquid cooling module 10 may be used as a part of electronic functional component package, to control a temperature of the electronic functional component. For example, FIG. 2 is an exploded view of a battery. A battery 30 may include a protective plate 31, a tray 32, a cell 33, and the liquid cooling module 10 that are sequentially stacked. As a part of the battery, the liquid cooling module 10 may control a temperature of the battery.

The following describes a temperature control function of the liquid cooling module 10.

Still refer to FIG. 1. The liquid cooling module 10 may include a liquid cooling component 100, a pump 200, and a working substance (not shown in the figure). A cavity of the liquid cooling component 100 is filled with the working substance. The pump 200 communicates with the cavity of the liquid cooling component 100. The pump 200 may be used as a power source of the working substance in the liquid cooling component 100, to provide flowing power for the working substance.

In a flowing process, the working substance may be used as a carrier for heat transfer, to take the heat away from the electronic functional component, so as to control a temperature of the electronic functional component.

In this embodiment of this application, the cavity of the liquid cooling component 100 provides a flowing track/place for flowing of the working substance. Therefore, in embodiments of this application, the cavity of the liquid cooling component 100 may be referred to as a flow channel.

A type of the pump 200 is not specifically limited in embodiments of this application. In some feasible implementations, the pump 200 may be a micro piezoelectric liquid pump. An amplitude of the micro piezoelectric liquid pump is less than or equal to 50 um. The micro piezoelectric liquid pump features ultra-thinness, a small size, a simple structure, high pressure, a small flow rate, no electromagnetic interference, and low operating noise, can implement precise fluid transmission and control, and is especially suitable for electronic devices such as a mobile phone, a watch, and an accessory.

In some related technologies, flowing of the working substance may be visualized, to achieve a flowing display region with a sense of science and technology. The flowing display region may be used to identify a component or beautify a housing, to improve user experience of using the electronic device.

Currently, an implementation of flowing visualization of the working substance in the liquid cooling module 10 is as follows: The transparent liquid cooling component 100 matches the working substance with flowing visualization. The working substance with flowing visualization is disposed in the transparent liquid cooling component 100, so that the liquid cooling module 10 can implement a flowing visualization function.

A working substance with a visible flowing state disclosed in a related technology includes water and a dye. The dye may color the working substance, so that a flowing process of the working substance can present flowing visualization effect.

The colored working substance may present the flowing visualization effect in a liquid cooling module 10 with a large size, but a size of the liquid cooling module 10 used in the electronic device is small (a cavity size of the liquid cooling module 10 is usually on a microliter-scale). As a result, the working substance disclosed in the related technology in the electronic device has poor flowing visualization effect.

To improve the flowing visualization effect of the working substance, an embodiment of this application discloses a working substance. Refer to FIG. 3. The working substance 300 may include a first medium 301 and a second medium 302. A liquid-liquid interface A exists between the second medium 302 and the first medium 301. A heat dissipation coefficient of the first medium 301 is greater than a heat dissipation coefficient of the second medium 302, so that the working substance including the first medium 301 has good heat dissipation performance, and the working substance can achieve good heat dissipation performance. The liquid-liquid interface A exists between the second medium 302 and the first medium 301. In a moving process of the working substance 300, the liquid-liquid interface A moves relative to an inner wall of an inner wall B of a cavity (used to load the working substance), so that movement of the working substance can present flowing visualization effect.

The following further describes components of the working substance disclosed in this embodiment of this application.

The working substance disclosed in this embodiment of this application includes the first medium. The first medium has good heat dissipation performance, to ensure that the working substance can achieve good heat dissipation performance. In addition, the first medium needs to form the liquid-liquid interface with the second medium, to ensure that the working substance can achieve flowing visualization effect.

A type of a medium included in the first medium is not specifically limited in embodiments of this application. Any medium that has good heat dissipation performance and that can form a liquid-liquid interface with the second medium may be used as the first medium in embodiments of this application.

For example, in some feasible implementations, the first medium may include water ($H_2O$), a liquid metal, and the like.

$H_2O$ and the liquid metal have good heat dissipation performance. $H_2O$ and the liquid metal may be used as the first medium, so that the working substance can achieve good heat dissipation performance, and the working substance can be ensured to achieve good heat dissipation performance.

In a feasible implementation, a mass fraction of the first medium in the working substance is greater than or equal to 50%. For example, the mass fraction of the first medium in the working substance may include 55%, 90%, 95%, or the like.

In this implementation, the mass fraction of the first medium in the working substance is greater than or equal to 50%, that is, the working substance includes a large amount of first medium (the first medium has good heat dissipation performance), to ensure that the working substance can achieve good heat dissipation performance. The working substance absorbs a large amount of heat per unit change in temperature, and the working substance can implement a good temperature control function.

To reduce impact of the working substance on an electromagnetic signal in an electronic device, in a feasible implementation, a conductivity of the first medium is less than or equal to 500 $\mu$s/cm. For example, the conductivity of the first medium may be 50 $\mu$s/cm, 10 $\mu$s/cm, 0.07 $\mu$s/cm, or the like.

In this implementation, the conductivity of the first medium is less than or equal to 500 $\mu$s/cm, and the first medium has a small conductivity, so that the working substance including the first medium has a small conductivity. When the working substance is used in the electronic device, the working substance may have small impact on an electromagnetic signal in the electronic device.

In an implementation in which the first medium includes water, the working substance may have a perfusion problem, causing the working substance to be attached to an inner wall of a cavity. Specifically, in a process of injecting the working substance into the inner wall of the cavity, the water in the working substance has large surface tension. As a result, it is difficult for the working substance to infiltrate the inner wall of the cavity, and the working substance is attached to the inner wall of the cavity, that is, a wall hanging phenomenon occurs. Specifically, refer to FIG. 4. It can be seen that the working substance 300 is attached to an inner wall of an inner wall B of the cavity.

To resolve the perfusion problem of the working substance, in a feasible implementation, the working substance may further include a first additive. The first additive may include a hydrophilic group and a hydrophobic group (which may also be referred to as a lipophilic group in this embodiment of this application), and is configured to reduce surface tension of the first medium, to improve infiltration performance of the working substance.

In the embodiments of this application, the hydrophilic group may be understood as a group (substituent) that is water-soluble or easily has an affinity to water. For example, the hydrophilic group may include but is not limited to hydroxyl (-OH), carbonyl (-C=O), and carboxyl (-COO-).

In the embodiments of this application, the hydrophobic group may be understood as a group (substituent) that has no affinity to water, is water-insoluble, or has an extremely low solubility. For example, the hydrophobic group may include but is not limited to alkyl, a benzene ring, and a group including a fluorocarbon bond (-C-F).

The first additive in this embodiment of this application may include the hydrophilic group and the hydrophobic group. The hydrophilic group of the first additive may be in contact with water, so that the hydrophobic group of the first additive faces a direction away from the water. In other words, the hydrophobic group wraps the water. The hydrophobic group is in contact with the inner wall of the cavity when the working substance is injected into the cavity, and the hydrophobic group has good infiltration performance to the cavity, thereby improving infiltration of the working substance to the inner wall of the cavity, and alleviating a problem of wall hanging of the working substance.

It is considered that a larger addition amount of the first additive indicates better infiltration performance of the working substance to the inner wall of the cavity and a smaller amount of the working substance hung on the wall.

In a feasible implementation, to make the working substance more easily infiltrate the inner wall of the cavity, a mass fraction of the first additive in the working substance may be greater than or equal to 0.01%.

It is considered that a larger addition amount of the first additive indicates a smaller proportion of the first medium in the working substance and corresponding poorer heat dissipation performance of the working substance.

In a feasible implementation, the mass fraction of the first additive in the working substance may be less than or equal to 20%, to obtain a working substance with good heat dissipation performance.

To balance the heat dissipation performance of the working substance and the infiltration performance to the inner wall of the cavity, in a feasible implementation, the mass fraction of the first additive in the working substance may range from 0.01% to 20%. Optionally, the mass fraction of the first additive in the working substance may range from 0.15% to 5%.

A type of the first additive is not specifically limited in embodiments of this application. Any additive that can

reduce the surface tension of the first medium may be used as the first additive in embodiments of this application.

For example, the first additive may include a fluorocarbon surfactant, a polyoxyethylene ether nonionic surfactant, a gemini (Gemini) surfactant, and the like.

The fluorocarbon surfactant may include at least one of ammonium perfluorohexylethyl sulfonate, ammonium perfluorohexylethyl phosphate, and perfluorohexylethyl polyoxyethylene ether.

In a feasible implementation, a molecular structural formula of the fluorocarbon surfactant may include:

$$F(CF_2)_xCH_2CH_2O(CH_2CH_2O)_y.$$

In $F(CF_2)_xCH_2CH_2O(CH_2CH_2O)_y$, a group including a fluorocarbon bond (C-F) may be used as the hydrophobic group, and an aldehyde group

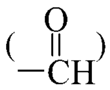

may be used as the hydrophilic group, so that the fluorocarbon surfactant whose molecular structure includes $F(CF_2)_xCH_2CH_2O(CH_2CH_2O)_y$ can reduce the surface tension of the first medium, thereby alleviating the problem of wall hanging of the working substance.

It is considered that a quantity of hydrophobic groups/hydrophilic groups in the fluorocarbon surfactant is related to a solubility of the fluorocarbon surfactant in the first medium/the second medium. Specifically, a larger quantity of hydrophobic groups in the fluorocarbon surfactant indicates a higher solubility of the fluorocarbon surfactant in the second medium, and a larger quantity of hydrophilic groups in the fluorocarbon surfactant indicates a higher solubility of the fluorocarbon surfactant in the first medium.

In a feasible implementation, in $F(CF_2)_xCH_2CH_2O(CH_2CH_2O)_y$, x=6, and y ranges from 5 to 14, to make the fluorocarbon surfactant exist on a surface of the first medium, so that the fluorocarbon surfactant can reduce the surface tension of the first medium.

In $F(CF_2)_xCH_2CH_2O(CH_2CH_2O)_y$ (the fluorocarbon surfactant/the first additive) disclosed in this implementation, x=6, and y ranges from 5 to 14. $F(CF_2)_xCH_2CH_2O(CH_2CH_2O)_y$ may exist on the surface of the first medium (the hydrophilic group faces the first medium, and the hydrophobic group faces away from the first medium), so that in a flowing process, the hydrophobic group is in contact with the inner wall of the cavity, to alleviate the problem of wall hanging of the first medium.

It is considered that a thermal stability of the first additive is related to a relative molecular mass of the first additive. Specifically, a larger relative molecular mass of the first additive indicates a better thermal stability of the fluorocarbon surfactant, and a smaller relative molecular mass of the first additive indicates a poorer thermal stability of the fluorocarbon surfactant.

To obtain a working substance with a good stability, in a feasible implementation, in $F(CF_2)_xCH_2CH_2O(CH_2CH_2O)_y$, y may be greater than or equal to 5, so that $F(CF_2)_xCH_2CH_2O(CH_2CH_2O)_y$ has a good thermal stability to obtain the working substance with a good thermal stability.

It is considered that a rigidity of the first additive is related to a molecular chain length of the first additive. Specifically, a shorter molecular chain of the first additive indicates a stronger rigidity of the first additive, and a longer molecular chain of the first additive indicates a weaker rigidity of the first additive.

In a feasible implementation, in $F(CF_2)_xCH_2CH_2O(CH_2CH_2O)_y$, y may be less than or equal to 14, so that $F(CF_2)_xCH_2CH_2O(CH_2CH_2O)_y$ has a shorter molecular chain, to ensure that $F(CF_2)_xCH_2CH_2O(CH_2CH_2O)_y$ has a higher rigidity. In a flowing process, $F(CF_2)_xCH_2CH_2O(CH_2CH_2O)_y$ can quickly reach between the first medium and the inner wall of the cavity, to reduce the surface tension of the first medium and suppress wall hanging of the working substance.

In a feasible implementation, a molecular structural formula of the polyoxyethylene ether nonionic surfactant includes:

$RO(CH_2CH_2O)_nH$,

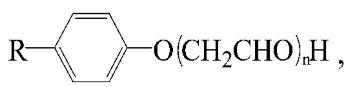

and the like. R is a hydrophobic group or hydrogen (H), and the hydrophilic group may include but is not limited to alkyl, cycloalkyl, and aryl.

In $RO(CH_2CH_2O)_nH$ and

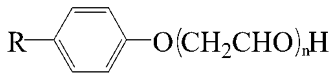 ,

R may be used as the hydrophobic group, and an ether bond (-O-) may be used as the hydrophilic group, so that the polyoxyethylene ether nonionic surfactant (the first additive) whose molecular structure includes $RO(CH_2CH_2O)_nH$ and

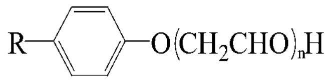

can reduce the surface tension of the first medium, thereby alleviating the problem of wall hanging of the working substance.

It is considered that the thermal stability of the first additive is related to the relative molecular mass of the first additive. In a feasible implementation, when R in $RO(CH_2CH_2O)_nH$ and

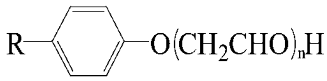

is alkyl, a quantity of carbon atoms in a main chain of R may be greater than or equal to 1; when R is cycloalkyl, a quantity of carbon atoms in a main chain of R may be greater than or equal to 3; or when R is aryl, a quantity of carbon atoms in a main chain of R may be greater than or equal to 4. In this way, the first additive has a good thermal stability, to obtain a working substance with a good thermal stability.

It is considered that the rigidity of the first additive is related to the molecular chain length of the first additive. In a feasible implementation, when R in $RO(CH_2CH_2O)_nH$ and

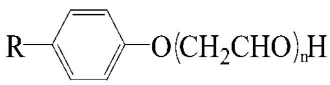

is alkyl, a quantity of carbon atoms in a main chain of R may be less than or equal to 15; when R is cycloalkyl, a quantity of carbon atoms in a main chain of R may be less than or equal to 12; or when R is aryl, a quantity of carbon atoms in a main chain of R may be less than or equal to 12, to ensure that the first additive has a large rigidity. In a flowing process, the first additive can quickly reach between the first medium and the inner wall of the cavity, to reduce the surface tension of the first medium and suppress wall hanging of the first medium.

In some feasible embodiments, n in $RO(CH_2CH_2O)_nH$ and

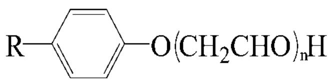

may range from 2 to 12. Optionally, n may range from 2 to 12.

In some feasible embodiments, a molecular structure of the gemini surfactant may be:

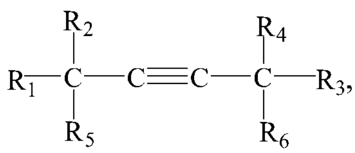 ,

where at least one of $R_1$, $R_2$, $R_3$, $R_4$, $R_5$, and $R_6$ is a hydrophilic group, and at least one of $R_1$, $R_2$, $R_3$, $R_4$, $R_5$, and $R_6$ is a hydrophobic group.

The hydrophilic group included in

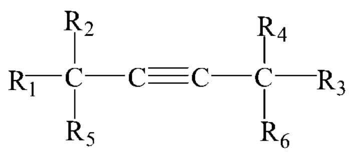

may include alkyl, alkoxy, aryl, fluoroalkyl, and the like. The hydrophobic group included in

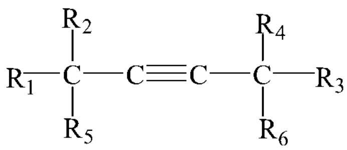

may include -OH , $-OCH_2CH_3$, $-OCH_2CH_2CH_3$, $-(OCH_2CH_2)_n-OH$, $-(OCH_2CH(CH_3))_n-OH$, and the like.

Optionally, in $-(OCH_2CH_2)_n-OH$, n may range from 1 to 5. In $-(OCH_2CH(CH_3))_n-OH$, n may range from 1 to 5.

A molecule of the gemini surfactant disclosed in this implementation includes the hydrophilic group and the hydrophobic group. In the working substance, the hydrophilic group of the gemini surfactant may be dissolved in the water, so that the hydrophobic group of the gemini surfactant faces away the water. In a flowing process, the hydrophobic group exists between the first medium and the inner wall of the cavity, to reduce the surface tension of the first medium and suppress wall hanging of the first medium.

In addition, the gemini surfactant disclosed in this implementation can quickly reach between the first medium and the inner wall of the cavity, to improve infiltration performance of the first medium to the inner wall of the cavity, thereby alleviating the problem of wall hanging of the first medium.

In a feasible implementation, each of $R_1$, $R_2$, $R_3$, and $R_4$ includes the hydrophobic group, and each of $R_5$ and $R_6$ includes the hydrophilic group.

For example, the molecular structure of the gemini surfactant may include

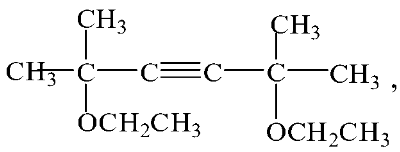 , 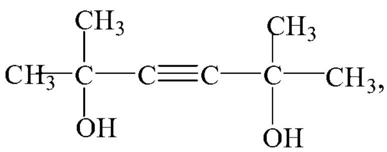,

and the like.

In the molecular structure of the gemini surfactant disclosed in this implementation, each of $R_1$, $R_2$, $R_3$, and $R_4$ includes the hydrophobic group, and each of $R_5$ and $R_6$ includes the hydrophilic group, so that the gemini surfactant has a higher rigidity. In a flowing process, the gemini surfactant disclosed in this implementation can quickly reach between the first medium and the inner wall of the cavity, to reduce the surface tension of the first medium and suppress wall hanging of the first medium.

The working substance disclosed in this embodiment of this application further includes the second medium. The second medium is used to form the liquid-liquid interface with the first medium, so that the working substance can move relative to the inner wall of the cavity in the flowing process, and the working substance presents flowing visualization effect.

It is considered that a larger addition amount of the second medium indicates a larger size of the liquid-liquid interface formed by the second medium and the first medium, and correspondingly, the working substance presents more significant flowing visualization effect.

In a feasible implementation, a mass fraction of the second medium in the working substance may be greater than or equal to 0.1%, to obtain a working substance with significant flowing visualization effect.

It is considered that a larger addition amount of the first additive indicates a smaller proportion of the first medium in the working substance and corresponding poorer heat dissipation performance of the working substance.

In a feasible implementation, the mass fraction of the second medium in the working substance may be less than or equal to 50%, to obtain a working substance with good heat dissipation performance.

In a feasible implementation, the mass fraction of the second medium in the working substance may range from 0.1% to 50%; optionally, the mass fraction of the second medium in the working substance may range from 1% to 20%; or optionally, the mass fraction of the second medium in the working substance may range from 5% to 10%, to balance the heat dissipation performance and the flowing visualization performance of the working substance.

In consideration of impact of the viscosity on the heat dissipation performance of the working substance, in a feasible implementation, a viscosity of the second medium is less than or equal to 100 mPa·s. For example, a viscosity of the first medium may be 50 mPa·s or 10 mPa·s.

In this implementation, in an environment of 25°C, the viscosity of the second medium is less than or equal to 100 mPa·s. The second medium has a low viscosity, so that the working substance has a low viscosity, resistance to the working substance is small in the flowing process, and the working substance can transfer a large amount of heat per unit time.

It should be noted that, when the working substance is in a static state, a liquid-liquid interface exists between the first medium and the second medium. When the working substance is in a flowing state, the first medium and the second medium may be emulsified, that is, the second medium is dispersed in the first medium in a form of small droplet. Specifically, refer to FIG. 5. It can be seen that after the first medium and the second medium are emulsified, the second medium is dispersed in the first medium in a form of small droplet to form an emulsion 400, and the liquid-liquid interface between the first medium and the second medium is broken. In this case, the working substance loses a flowing visualization function.

To obtain a working substance with a stable flowing visualization function, in a feasible implementation, the working substance may further include a second additive, where the second additive is used to break an emulsion. The emulsion may be understood as a solution formed by dispersing the second medium in a form of small droplet in the first medium.

A specific demulsification process may be as follows:

A bonding capability between the second additive and $H_2O$ (the first medium) is stronger than a bonding capability between the second medium and $H_2O$. When the second medium is dispersed in a form of small droplet in $H_2O$ to form an emulsion, $H_2O$ is preferably bonded with the second additive. In this way, a thickness of a hydrated layer on a surface of the small droplet is decreased, and the second medium existing in the form of small droplet tends to aggregate to form the second medium existing in a continuous phase form (the liquid-liquid interface exists between the second medium existing in the continuous phase form and the first medium), so as to restore the liquid-liquid interface between the first medium and the second medium, thereby achieving demulsification effect.

The working substance disclosed in this implementation includes the second additive. The second additive can break the emulsion formed by the first medium and the second medium, to restore the liquid-liquid interface between the first medium and the second medium, so that the working substance has a stable liquid-liquid interface, and the working substance can have stable flowing visualization effect.

The second additive is not specifically limited in embodiments of this application. Any additive that can break the emulsion formed by the first medium and the second medium may be used as the second additive in embodiments of this application.

For example, the second additive may include at least one of an organic alcohol compound, an organic ketone compound, an amine compound, an organic acid compound, a lipid organic compound, an ether organic compound, an aromatic compound, and silicone oil.

The organic alcohol compound includes a hydrophilic group hydroxyl (-OH), so that a bonding capability between the organic alcohol compound and $H_2O$ (the first medium) is stronger than a bonding capability between the second medium and $H_2O$. Therefore, the organic alcohol compound may be used as the second additive in embodiments of this application.

For example, a molecular structural formula of the organic alcohol compound may include $C_nH_{(2n+2-m)}(OH)_m$.

It is considered that the thermal stability of the working substance is related to a relative molecular mass of the second additive. Specifically, a larger relative molecular mass of the second additive indicates a better thermal stability of the second additive and a corresponding better thermal stability of the working substance including the second additive. The thermal stability may include but is not limited to a thermal stability.

In a feasible implementation, n in $C_nH_{(2n+2-m)}(OH)_m$ (the second additive) is greater than or equal to 1, so that the second additive has a high thermal stability, and the working substance including the second additive has a good thermal stability, to obtain a working substance with a good thermal stability.

It is considered that a rigidity of the second additive is related to the relative molecular mass of the second additive. Specifically, a smaller relative molecular mass of the second additive indicates a better rigidity of the second additive. When the first medium and the second medium are emulsified, the second additive can quickly reach between the second medium existing in the form of small droplet and the first medium, to implement a demulsification function (that is, the second additive may have high demulsification efficiency), so that the working substance can quickly restore the liquid-liquid interface.

In a feasible implementation, n in $C_nH_{(2n+2-m)}(OH)_m$ (the second additive) is less than or equal to 12, so that the second additive has a high rigidity, and the working substance including the second additive can quickly restore the liquid-liquid interface after emulsification, that is, the working substance has a stable liquid-liquid interface, to obtain a working substance that can quickly restore the liquid-liquid interface after emulsification.

In a feasible implementation, n in $C_nH_{(2n+2-m)}(OH)_m$ may range from 1 to 12, so that the working substance has both the high thermal stability and the stable liquid-liquid interface.

It is considered that a polarity of the second additive is related to a quantity of hydroxyl groups in the organic alcohol compound. Specifically, a larger quantity of hydroxyl groups in the organic alcohol compound indicates a higher polarity of the organic alcohol compound and a higher solubility of the organic alcohol compound in the first medium, and a smaller quantity of the hydroxyl groups in the organic alcohol compound indicates a lower polarity of the organic alcohol compound and a higher solubility of the organic alcohol compound in the second medium.

In a feasible implementation, m in $C_nH_{(2n+2-m)}(OH)_m$ may range from 1 to 4, to make the organic alcohol compound exist between the first medium and the second medium, to better implement a demulsification function.

For example, a molecular structural formula of the organic alcohol compound may include $Ar-(OH)_n$, and Ar may include a cyclic group. The cyclic group may include cycloalkyl, an aromatic ring, and the like.

In a feasible implementation, the cycloalkyl may include $C_4$-$C_{12}$ cycloalkyl. For example, the cycloalkyl may include

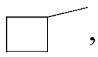, 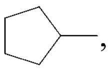, and 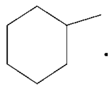.

The aromatic ring may be understood as a group including a benzene ring. In a feasible implementation, the aromatic ring may include a $C_4$-$C_{12}$ aromatic ring. For example, the aromatic ring may include

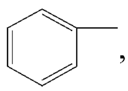, 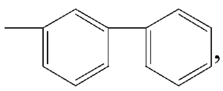, 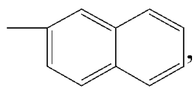,

and the like.

In some feasible implementations, the organic alcohol compound may include polyethylene glycol.

In this embodiment of this application, the organic ketone compound may be understood as an organic compound including a hydrophilic group carbonyl (-C=O), and the organic ketone compound may be used as a second additive in embodiments of this application.

For example, a molecular structural formula of the organic ketone compound may include $R_1$-CO-$R_2$. Each of $R_1$ and $R_2$ may include a hydrophobic group such as alkyl, cycloalkyl, or aryl.

In some feasible implementations, each of $R_1$ and $R_2$ in $R_1$-CO-$R_2$ may include at least one of $C_1$ - $C_{15}$ alkyl, $C_3$ - $C_{15}$ cycloalkyl, or $C_4$-$C_{12}$ aryl, so that $R_1$-CO-$R_2$ has an appropriate polarity, and may massively exist between the first medium and the second medium, to implement a demulsification function. In this implementation, the working substance may further have both a high thermal stability and a stable liquid-liquid interface.

In a feasible implementation, the second additive may include an amine compound. The amine compound includes a hydrophilic group amino (-NH-), and the amine compound may be used as a second additive in embodiments of this application.

For example, a molecular structural formula of the amine compound may include at least one of $RNH_2$, $R_1$-NH-$R_2$, and $R_1$-N($R_2$)-$R_3$.

In some feasible implementations, in $RNH_2$, $R_1$-NH-$R_2$, and $R_1$-N($R_2$)-$R_3$, each of R, $R_1$ $R_2$, and $R_3$ may include at least one of $C_1$ - $C_{15}$ alkyl, $C_3$ - $C_{15}$ cycloalkyl, and $C_4$-$C_{12}$ aryl. In this way, each of $RNH_2$, $R_1$-NH-$R_2$, and $R_1$-N($R_2$)-$R_3$ has an appropriate polarity, and may massively exist between the first medium and the second medium, to implement a demulsification function. In this implementation, the working substance may further have both a high thermal stability and a stable liquid-liquid interface.

In this embodiment of this application, the ether compound is an organic compound including a hydrophilic group ether bond (-O-), and the ether compound may be used as a second additive in embodiments of this application.

For example, a molecular structural formula of the ether compound may include $R_1$-O-$R_2$.

In some feasible implementations, in $R_1$-O-$R_2$, each of $R_1$ and $R_2$ may include at least one of $C_1$ - $C_{15}$ alkyl, $C_3$ - $C_{15}$ cycloalkyl, and $C_4$ - $C_{12}$ aryl. In this way, $R_1$-O-$R_2$ has an appropriate polarity, and may massively exist between the first medium and the second medium, to implement a demulsification function. In this implementation, the working substance may further have both a high thermal stability and a stable liquid-liquid interface.

In this embodiment of this application, the lipid compound may be understood as an organic compound including a hydrophilic group ester group

(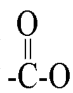),

and the lipid compound may be used as a second additive in embodiments of this application.

For example, a molecular structural formula of the lipid compound may include $R_1$-COO-$R_2$.

In some feasible implementations, in $R_1$-COO-$R_2$ , each of $R_1$ and $R_2$ may include at least one of $C_1$-$C_{15}$ alkyl, $C_3$-$C_{15}$ cycloalkyl, and $C_4$-$C_{12}$ aryl. In this way, $R_1$-COO-$R_2$ has an appropriate polarity, and may massively exist between the first medium and the second medium, to implement a demulsification function. In this implementation, the working

substance may further have both a high thermal stability and a stable liquid-liquid interface.

In this embodiment of this application, the organic acid compound may be understood as an organic compound including a hydrophilic group carboxyl

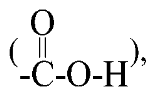

and the organic acid compound may be used as a second additive in embodiments of this application.

For example, a molecular structural formula of the organic acid compound may include $C_nH_{2n+1}COOH$.

In some feasible implementations, in $C_nH_{2n+1}COOH$ , n may range from 1 to 12, so that $C_nH_{2n+1}COOH$ has an appropriate polarity, and may massively exist between the first medium and the second medium, to implement a demulsification function. In this implementation, the working substance may further have both a high thermal stability and a stable liquid-liquid interface.

In this embodiment of this application, a heterocyclic compound (heterocyclic compound) may be understood as an organic compound including a heterocyclic structure in a molecule. In addition to a carbon atom, an atom forming a ring further includes at least one heteroatom (for example, N or O), and the heteroatom may be used as a hydrophilic group, so that the lipid compound may be used as a second additive in embodiments of this application.

For example, the heterocyclic compound may include at least one of pyridine, furan, thiophene, pyrrole, piperidine, tetrahydrofuran, thiazole, imidazole, pyrazole, quinoline, isoquinoline, indole, and purine.

In a feasible implementation, the second additive may include an organic salt, and the organic salt may include an organic anion and a cation. The cation may include an ammonium ion ( $-NH_3^+$ ) or a metal ion.

Each of the organic anion and the cation has a strong hydrophilic property. In this way, the organic anion may form a hydrated anion with $H_2O$, and the cation may form a hydrated cation with $H_2O$. In other words, $H_2O$ tends to bond with the cation/organic anion.

When the second medium is dispersed in the form of small droplet in $H_2O$ to form the emulsion, $H_2O$ is preferably bonded with the cation and the organic anion. As a result, the thickness of the hydrated layer on the surface of the small droplet is decreased, and small droplets tend to aggregate to form the second medium in the continuous phase, so as to restore the liquid-liquid interface between the first medium and the second medium.

For example, the organic salt may include tetradecyl trimethyl ammonium chloride, didecyl dimethyl ammonium chloride, and the like.

In a feasible implementation, the second additive may include silicone oil. The silicone oil is a type of organic compound containing dimethyl. The dimethyl may be used as a hydrophilic group, so that the silicone oil may be used as a second additive in embodiments of this application.

In some feasible implementations, a molecular structural formula of the silicone oil (the second additive) includes:

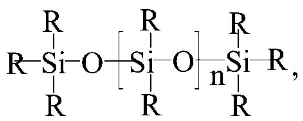

where R is a hydrophobic group or hydrogen. The hydrophobic group may include methyl, methoxy, ethyl, ethoxy, propyl, butyl, pentyl, hexyl, heptyl, octyl, phenyl, hydroxyl, vinyl, and the like. A side chain of R may be preferably a $C_3$-$C_{18}$ alkyl substituent.

In this implementation,

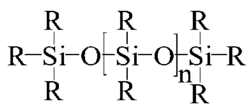

includes a hydrophilic group silicon-oxygen bond (-Si-O). In addition, R includes H, methyl, methoxy, ethyl, ethoxy, propyl, butyl, pentyl, hexyl, heptyl, octyl, phenyl, hydroxyl, vinyl, and the like, so that the bonding capability between

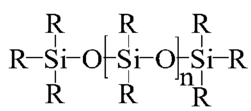

and the first medium is stronger than the bonding capability between the second medium and the first medium. After the first medium and the second medium are emulsified, the first medium is preferably bonded with

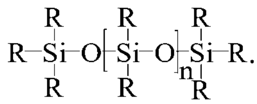

In this way, the thickness of the hydrated layer on the surface of the small droplet is decreased, and the second medium existing in the form of small droplet tends to aggregate to form the second medium existing in the continuous phase form, so as to restore the liquid-liquid interface between the first medium and the second medium, thereby achieving the demulsification effect.

In a feasible implementation, n in

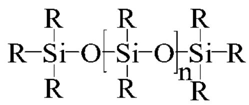

(the second additive) is greater than or equal to 0, so that the second additive has a high thermal stability, and the working substance including the second additive has a good thermal stability.

It is considered that the rigidity of the second additive is related to the relative molecular mass of the second additive. In a feasible implementation, n in

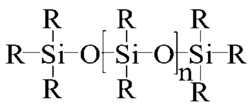

(the second additive) is less than or equal to 100, so that the second additive has a high rigidity, and the working substance including the second additive can quickly restore the liquid-liquid interface after emulsification, that is, the working substance has a stable liquid-liquid interface, to obtain a working substance that can quickly restore the liquid-liquid interface after emulsification.

In a feasible implementation, n in

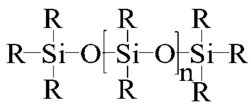

may range from 0 to 100. Optionally, n may range from 10 to 40, so that the working substance has both the high thermal stability and the stable liquid-liquid interface.

It should be noted that in embodiments of this application, several second additives are merely disclosed as examples, and the additive does not constitute a specific limitation. Any additive that can break the emulsion formed by the first medium and the second medium may be used as the second additive in embodiments of this application. For example, the second additive may further include a copolymer of ethylene oxide and propylene oxide or the like.

In consideration of a larger addition amount of the second additive, when the first medium and the second medium are emulsified, the second additive can quickly reach between the second medium existing in the form of small droplet and the first medium, to implement a demulsification function (that is, the second additive may have high demulsification efficiency), so that the working substance can quickly restore the liquid-liquid interface.

In a feasible implementation, a mass fraction of the second additive in the working substance may be greater than or equal to 0.01%, to obtain a working substance with stable flowing visualization effect.

It is considered that a larger addition amount of the second additive indicates a smaller proportion of the first medium in the working substance and corresponding poorer heat dissipation performance of the working substance.

In a feasible implementation, the mass fraction of the second additive in the working substance may be less than or equal to 20%, to obtain a working substance with good heat dissipation performance.

In a feasible implementation, the mass fraction of the second additive in the working substance may range from 0.01% to 20%, or optionally, the mass fraction of the second medium in the working substance may range from 0.1% to 5%, to balance the heat dissipation performance and the flowing visualization performance of the working substance.

By now, the description of the second additive is completed, and the following continues to describe the second

medium.

The second medium is not specifically limited in embodiments of this application. Any medium that can form a liquid-liquid interface with the first medium may be used as the second medium in embodiments of this application.

For example, the second medium may include hydrocarbon (hydrocarbon), a heterocyclic compound (heterocyclic compound), a fluorinated liquid (fluorinated liquid), mineral oil, and silicone oil.

A quantity of second media included in the working substance is not specifically limited in embodiments of this application. For example, the quantity of second media included in the working substance may be 1, 2, 3, or the like.

Dissolution between the second media is not specifically limited in embodiments of this application.

In some feasible implementations, at least two second media are miscible with each other.

For example, the second medium may include hydrocarbon and a heterocyclic compound. The hydrocarbon and the heterocyclic compound are miscible with each other to form a homogeneous phase.

For example, the second medium may include hydrocarbon, a heterocyclic compound, and mineral oil. The hydrocarbon and the heterocyclic compound are miscible with each other to form a mixed organic liquid. A liquid-liquid interface is formed between the mineral oil and the mixed organic liquid (they are immiscible with each other).

In some feasible implementations, a liquid-liquid interface exists between any two second media.

For example, the second medium may include a fluorinated liquid and mineral oil. The fluorinated liquid and the mineral oil may form a liquid-liquid interface.

It should be noted that in embodiments of this application, dissolution between several second media is merely described as examples, and the foregoing examples do not constitute a specific limitation.

In this embodiment of this application, the hydrocarbon may be understood as an organic compound including a carbon element (C) and a hydrogen element (H). Fluorinated hydrocarbon has a low solubility in the first medium, and the hydrocarbon may form a liquid-liquid interface with the first medium.

For example, a molecular structure of the hydrocarbon may include $CH_3$-$(CH_2)_n$-$CH_3$.

It is considered that a stability of the liquid-liquid interface is related to a solubility of the second medium in the first medium. Specifically, a larger relative molecular mass of the second medium indicates a lower solubility of the second medium in the first medium, a more stable liquid-liquid interface between the second medium and the first medium, and more stable flowing visualization effect of the working substance.

In a feasible implementation, n in $CH_3$-$(CH_2)_n$-$CH_3$ (the second medium) may be greater than or equal to 5, so that the solubility of the second medium in the first medium is low, to ensure that a stable liquid-liquid interface exists between the first medium and the second medium, and ensure that the working substance can achieve stable flowing visualization effect, so as to obtain a working substance with stable flowing visualization effect.

It is considered that the stability of the liquid-liquid interface is related to a thermal stability of the second medium. Specifically, a larger relative molecular mass of the second medium indicates a higher thermal stability of the second medium, a better thermal stability of the second medium, a more stable liquid-liquid interface between the second medium and the first medium, and more stable flowing visualization effect of the working substance.

In this implementation, n in $CH_3$-$(CH_2)_n$-$CH_3$ (the second medium) may be greater than or equal to 5, so that the thermal stability of the second medium is high, and the second medium and the first medium can form a stable liquid-liquid interface, to ensure that the working substance can have stable flowing visualization effect.

It is considered that heat dissipation performance of the working substance is related to a viscosity of the second medium. Specifically, a smaller relative molecular mass of the second medium indicates a lower viscosity of the second medium, smaller resistance to the working substance in a flowing process, lower heat transferred by the working substance per unit time, and better heat dissipation performance of the working substance.

In a feasible implementation, n in $CH_3$-$(CH_2)_n$-$CH_3$ may be less than or equal to 11, to further improve the heat dissipation performance of the working substance.

In this implementation, n in $CH_3$-$(CH_2)_n$-$CH_3$ is less than or equal to 11, so that the second medium has a low viscosity, to ensure small resistance to the working substance in a flowing process and a large amount of heat transferred by the working substance per unit time, and ensure the working substance can achieve good heat dissipation performance.

In a feasible implementation, n in $CH_3$- $(CH_2)_n$-$CH_3$ may range from 5 to 11, to balance the stable flowing visualization effect and the good heat dissipation performance of the working substance.

For example, a molecular structure of the hydrocarbon may include

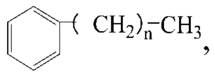,

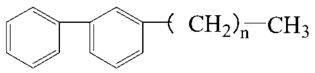, 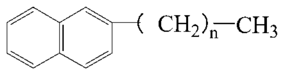, 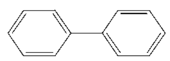, 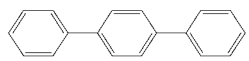,

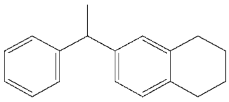, 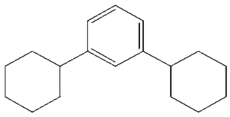, 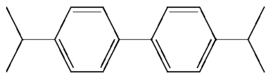, 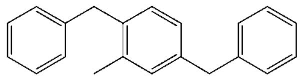,

and the like.

In this implementation, the hydrocarbon (the second medium) includes a benzene ring

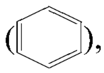,

and the benzene ring has a high rigidity, so that the hydrocarbon has a high rigidity. When the hydrocarbon and the first medium are emulsified, because the hydrocarbon has the high rigidity, under an action of the first additive, the hydrocarbon existing in a form of small droplet can quickly get rid of a constraint of the first medium and aggregate to form the hydrocarbon in a continuous phase, so that the working substance restores the visualization effect.

In a feasible implementation, n in

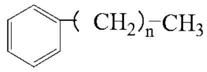

may be greater than or equal to 5; n in

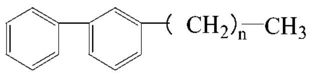

may be greater than or equal to 0; and n in

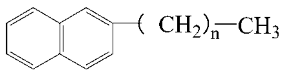

may be greater than or equal to 0, to obtain a working substance with stable flowing visualization effect.

In a feasible implementation, n in

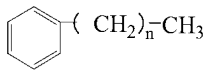

may be less than or equal to 11; n in

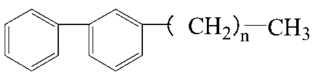

may be less than or equal to 5; and n in

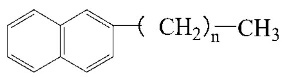

may be less than or equal to 5, to obtain a working substance with good heat dissipation performance.

In some feasible implementations, n in

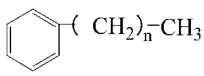

may range from 5 to 11, n in

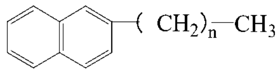

may range from 0 to 5, n in

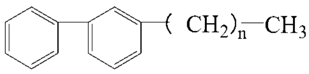

may range from 5 to 11, to balance both the heat dissipation performance and the flowing visualization performance of the working substance.

In this embodiment of this application, the heterocyclic compound may be understood as a compound that contains, in addition to carbon and hydrogen atoms, heteroatoms such as an oxygen (O) atom, a sulfur (S) atom, a nitrogen (N) atom. The heterocyclic compound may form a liquid-liquid interface with the first medium.

For example, a molecular structure of the heterocyclic compound may include:

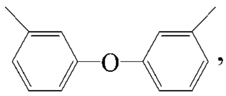 , 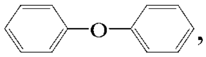 ,

and the like.

In this implementation, the molecular structure of the heterocyclic compound (the second medium) includes a benzene ring, and the benzene ring has a high rigidity, so that the heterocyclic compound has a high rigidity. When the heterocyclic compound and the first medium are emulsified, because the heterocyclic compound has the high rigidity, under an action of the second additive, the heterocyclic compound can quickly get rid of a constraint of the first medium and aggregate to form the second medium, so that the working substance restores the visualization effect.

In this embodiment of this application, the fluorinated liquid may be understood as an organic compound including a fluorocarbon bond (C-F) in a molecular structural formula. A group formed by the fluorocarbon bond (C-F) is a hydrophobic group, so that the fluorinated liquid has a low solubility in the first medium, and the fluorinated liquid can form a liquid-liquid interface with the first medium. For example, the fluorinated liquid may include at least one of fluoroalkane and hydrofluoroether.

It is considered that the stability of the liquid-liquid interface is related to the solubility of the second medium in the first medium. In a feasible implementation, a quantity of carbon atoms in a main chain of the fluorinated liquid may be greater than or equal to 5, so that a solubility of the fluorinated liquid in the first medium is low, to ensure that a stable liquid-liquid interface exists between the fluorinated liquid and the second medium, and ensure that the working substance can achieve stable flowing visualization effect, so as to obtain a working substance with stable flowing visualization effect.

It is considered that the stability of the liquid-liquid interface is related to a thermal stability of the second medium. In a feasible implementation, the quantity of carbon atoms in the main chain of the fluorinated liquid may be greater than or equal to 5, so that the fluorinated liquid has a high thermal stability, that is, the fluorinated liquid has a good thermal stability, the fluorinated liquid is not easy to volatilize, and the fluorinated liquid can form a stable liquid-liquid interface with the first medium, to ensure that the working substance can have stable flowing visualization effect.

It is considered that heat dissipation performance of the second medium is related to a viscosity of the second medium. In a feasible implementation, the quantity of carbon atoms in the main chain of the fluorinated liquid may be less than or equal to 11, so that the fluorinated liquid has a low viscosity, to ensure small resistance to the working substance in a flowing process and a large amount of heat transferred by the working substance per unit time, and ensure that the working substance can achieve good heat dissipation performance, so as to further improve the heat dissipation performance of the working substance.

In a feasible implementation, the quantity of carbon atoms in the main chain of the fluorinated liquid may range from 5 to 8, to balance the stable flowing visualization effect and the good heat dissipation performance of the working substance.

For example, a molecular structure of the fluorinated liquid may include:
at least one of

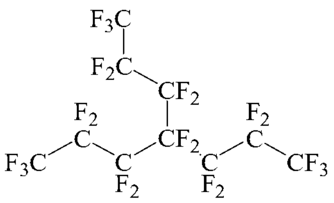 , 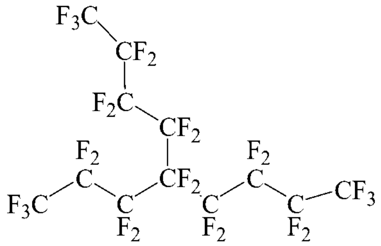 ,

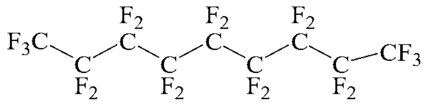 , 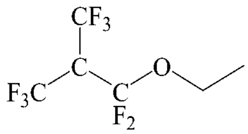 , 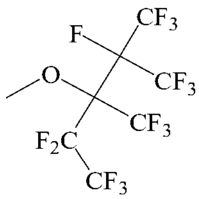 , 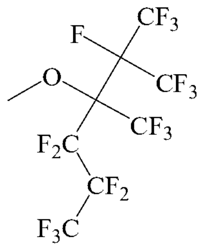 ,

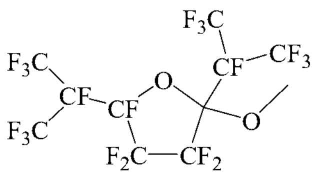 , 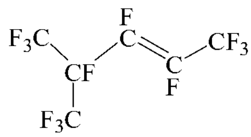 , 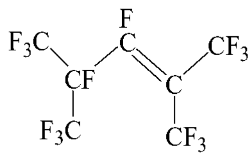 , 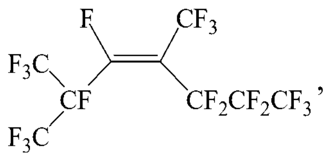

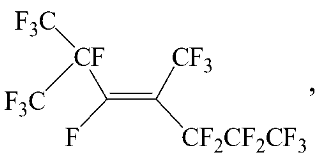 , 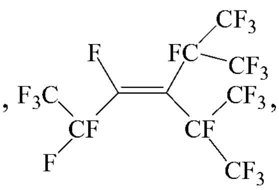 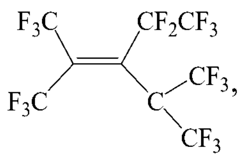 and 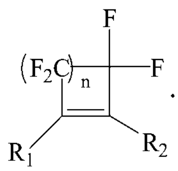 .

In

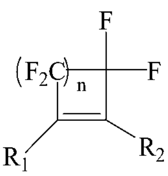 ,

$R_1$ is fluorine (F) or perfluoroalkyl ($-C_xF_{2x+1}$), and $R_2$ is perfluoroalkyl, and may include 1, 2, 3, and the like.

When the silicone oil is used as the second medium, a molecular structural formula of the silicone oil may include

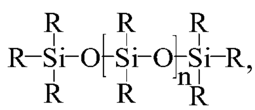

so that a liquid-liquid interface can exist between

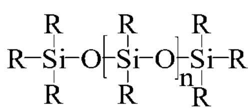

and the first medium.

For example, R may include

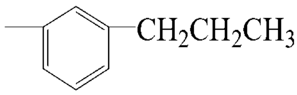, 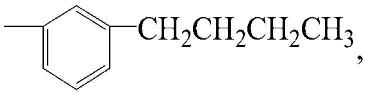,

and the like.

By now, the description of the second medium is completed.

In a feasible implementation, the working substance may further include a water-soluble dye. The water-soluble dye in this application may be understood as a dye for coloring the first medium. A solubility of the water-soluble dye in the first medium is greater than a solubility of the water-soluble dye in the second medium. In this embodiment of this application, the water-soluble dye may also be referred to as an inorganic dye.

For example, the water-soluble dye may include but is not limited to methyl orange and methyl blue.

In a feasible implementation, the water-soluble dye may include a colored salt. The colored salt may be understood as a salt whose aqueous solution is colored. The colored salt may include an inorganic anion and a cation. For example, the colored salt may include but is not limited to copper sulfate ($CuSO_4$), copper chloride ($CuCl_2$), copper nitrate ($Cu(NO_3)_2$), ferrous sulfate ($FeSO_4$), ferrous chloride ($FeCl_2$), ferrous nitrate ($Fe(NO_3)_2$), ferric sulfate ($Fe_2(SO_4)_3$), ferric chloride ($FeCl_3$), ferric nitrate ($Fe(NO_3)_3$), potassium permanganate ($KMnO_4$), cobalt chloride ($CoCl_2{\cdot}n(H_2O)$), cobalt sulfate ($CoSO_4$), cobalt nitrate ($Co(NO_3)_2$), nickel chloride ($NiCl_2$), nickel sulfate ($NiSO_4$), and nickel nitrate ($Ni(NO_3)_2$).

When the second medium is dispersed in the form of small droplet in $H_2O$ to form the emulsion, $H_2O$ is preferably bonded with the cation and the inorganic anion. As a result, the thickness of the hydrated layer on the surface of the small droplet is decreased, and small droplets tend to aggregate to form the second medium in the continuous phase, so as to restore the liquid-liquid interface between the first medium and the second medium.

In this implementation, the working substance includes the water-soluble dye. The water-soluble dye may color the first medium. The solubility of the water-soluble dye in the first medium is greater than the solubility of the water-soluble dye in the second medium. Introduction of the water-soluble dye may make the first medium and the second medium have a large color contrast, so that the working substance can have significant flowing visualization effect.

In a feasible implementation, the working substance may further include an oil-soluble dye. The oil-soluble dye in this application may be understood as a dye for coloring the second medium. A solubility of the oil-soluble dye in the second medium is greater than a solubility of the oil-soluble dye in the first medium. In this embodiment of this application, the oil-soluble dye may also be referred to as an organic dye.

In this implementation, the working substance includes the oil-soluble dye. The oil-soluble dye may color the second medium. The solubility of the oil-soluble dye in the second medium is greater than the solubility of the oil-soluble dye in the first medium. Introduction of the oil-soluble dye may make the second medium and the first medium have a large color contrast, so that the working substance can have significant flowing visualization effect.

It should be noted that, in the implementation in which the working substance includes the water-soluble dye and the oil-soluble dye, the oil-soluble dye and the water-soluble dye need to have different colors, so that the second medium and the first medium have a large color contrast. For example, a red water-soluble dye and a blue oil-soluble dye may be selected.

In a feasible implementation, the working substance may further include a colorless salt, which may include but is not limited to sodium chloride (NaCl), magnesium chloride ($MgCl_2$), calcium chloride ($CaCl_2$), and aluminum nitrate ($Al(NO_3)_4$). The colorless salt can implement a demulsification function.

In a feasible implementation, the working substance may further include an inorganic acid. For example, the inorganic acid may include a hydrochloric acid (HCl), a sulfuric acid, and the like. The inorganic acid can implement a demulsification function.

In a feasible implementation, the working substance may further include an inorganic acid. For example, the inorganic acid may include a hydrochloric acid (HCl), a sulfuric acid, and the like. The inorganic acid can implement a demulsification function.

The following further describes the working substance disclosed in this embodiment of this application with reference to specific examples.

Embodiment 1

Embodiment 1 discloses a working substance with a high thermal conductivity and flowing visualization effect. For components included in the working substance, refer to Table 1.

Table 1

| Components | Addition amount (by mass) |
|---|---|
| Water (first medium) | 90 parts |
| Fluorocarbon surfactant (first additive) | 0.03 part |
| n-hexanol (second additive) | 3 parts |
| Acetic acid (second additive) | 1 part |
| Silicone oil ($\eta$=10 cP) (second medium) | 5 parts |
| Water-soluble blue dye | 0.03 part |
| Oil-soluble red dye | 0.03 part |

The working substance disclosed in Embodiment 1 has the following effect:

The first medium includes water with good heat dissipation performance, to ensure that the working substance has an excellent heat dissipation capability. A temperature difference between points of the liquid cooling working substance is less than 3°C.

In the working substance, the second medium includes the silicone oil. The silicone oil can form a liquid-liquid interface with water, so that a flowing state of the working substance has visualization effect.

The working substance further includes the water-soluble blue dye and the oil-soluble red dye. The water-soluble blue dye is dissolved in the first medium, so that the first medium is blue. The oil-soluble red dye is dissolved in the second medium, so that the second medium is red. The first medium and the second medium have a strong color contrast, so that the flowing visualization effect of the working substance is enhanced.

Embodiment 2

Embodiment 2 discloses a working substance with a high thermal conductivity and flowing visualization effect. For components included in the working substance, refer to Table 2.

Table 2

| Components | Addition amount (by mass) |
|---|---|
| Deionized water (first medium) | 90 parts |
| Polyoxyethylene ether surfactant (first additive) | 1 part |
| Gemini surfactant (first additive) | 1.5 parts |
| Hydrocarbon (second medium) | 5 parts |
| Fluorinated liquid (second medium) | 5 parts |
| Copper chloride (second additive) | 5 parts |
| Water-soluble blue dye | 0.01 part |

The working substance disclosed in Embodiment 2 has effect similar to that of the working substance disclosed in Embodiment 1. A difference is as follows:

The working substance disclosed in Embodiment 2 includes three liquid-liquid interfaces: a liquid-liquid interface formed by the water and the hydrocarbon, a liquid-liquid interface formed by the fluorinated liquid and the hydrocarbon, and a liquid-liquid interface formed by the water and the fluorinated liquid.

In the working substance in Embodiment 2, the polyoxyethylene ether surfactant and the gemini surfactant are used as the first additive. The gemini surfactant has high demulsification efficiency.

When the copper chloride (the second additive) is used as the second additive, the copper chloride (dissolved in the first medium) assists in coloring, and the first medium and the second medium have a strong color contrast, so that the flowing visualization effect of the working substance is enhanced.

Embodiment 3

Embodiment 3 discloses a working substance with a high thermal conductivity and flowing visualization effect.

For components included in the working substance, refer to Table 3.

Table 3

| Components | Addition amount |
|---|---|
| Deionized water (first medium) | 85 parts |
| Ethanol (second additive) | 10 parts |
| Polyoxyethylene ether surfactant (first additive) | 1 part |
| Butanol (second additive) | 4 parts |
| Sodium alkyl naphthalene sulfonate (second additive) | 0.5 part |
| Fluorinated liquid (second medium) | 10 parts |
| Blue fluorescent dye (dye) | 0.01 part |

For effect that can be achieved by the working substance disclosed in Embodiment 3, refer to effect that can be achieved by the working substance disclosed in Embodiment 1.

By now, the description of the working substance is completed.

An embodiment of this application further discloses a liquid cooling module. The liquid cooling module may include a pump and a working substance. The pump communicates with the working substance, and the pump is configured to drive the working substance to move. In a moving process of the working substance, a liquid-liquid interface formed by a first medium and a second medium moves relative to an inner wall of a cavity, so that movement of the working substance can present flowing visualization effect. In other words, the liquid cooling module forms a flowing visualization region.

An embodiment of this application further discloses an electronic device. Refer to FIG. 6 to FIG. 11. The electronic device 1 may include a liquid cooling module 10 and a housing 20 that are disclosed in embodiments of this application. The liquid cooling module 10 is embedded into the housing 20, and visible light transmittance of at least a partial region of the housing covering the liquid cooling module 10 is greater than or equal to a threshold.

The threshold is not specifically limited in embodiments of this application. For example, the threshold may include 50%, 80%, 90%, or the like.

The liquid cooling module 10 may include a pump 200 and a working substance (not shown in the figure). The working substance may include a first medium and a second medium. The pump 200 is used as a power source of the working substance to drive the working substance to move. In a moving process of the working substance, a liquid-liquid interface moves relative to a cavity configured to accommodate the working substance, to achieve significant flowing visualization effect.

The liquid cooling module 10 is embedded into the housing 20, and the visible light transmittance of at least the partial region of the housing covering the liquid cooling module 10 is greater than or equal to the threshold, so that the flowing visualization effect of the working substance can be displayed through the housing in the region. In other words, the region of the housing becomes a flowing visualization region 2A.

Refer to FIG. 10. In a feasible implementation, the liquid cooling module 10 may further include a liquid cooling component 100. The liquid cooling component 100 has a cavity B configured to accommodate the working substance, and the cavity B of the liquid cooling component 100 communicates with the pump 200.

Refer to FIG. 11. In a feasible implementation, the housing 20 has a groove B, the groove B is used as a cavity configured to accommodate the working substance, and the groove B communicates with the pump 200.

The electronic device disclosed in this embodiment of this application may include but is not limited to a mobile phone (FIG. 6), a tablet computer (FIG. 7), a notebook computer (FIG. 8), and a vehicle-mounted device (FIG. 9).

The following further describes the electronic device disclosed in this embodiment of this application with reference to a specific example.

For example, refer to (I) in FIG. 6. The liquid cooling module 10 is embedded into a housing 20 of the mobile phone, and visible light transmittance of the housing 20 of the mobile phone in a region 2A of a camera substrate is greater than or equal to the threshold. Movement of the liquid-liquid interface of the working substance relative to the cavity may be observed through the region 2A, so that the region 2A becomes a flowing visualization region 2A.

For example, refer to (II) in FIG. 6. The liquid cooling module 10 is embedded into a housing 20 of the mobile phone, and the housing of the mobile phone includes a first non-folding part 21, a folding part 23, and a second non-folding part 22, visible light transmittance of a partial region of the first non-folding part 21, a partial region of the folding part 23, and a partial region of the second non-folding part 22 is greater than or equal to the threshold (transparent region), and a cross-axis flowing visualization region 2A may be formed in the transparent region.

For example, refer to FIG. 7. The liquid cooling module 10 is embedded into a housing 20 of the tablet computer, visible light transmittance of at least a partial region of the housing 20 of the tablet computer is greater than or equal to the threshold, and a flowing visualization region 2A is formed in the region.

For example, refer to FIG. 8. A housing of the notebook computer may include a body housing 24 and a display housing 25. Refer to (I) in FIG. 8. In some feasible implementations, the liquid cooling module 10 is embedded into the body housing 24, so that the body housing 24 can have a flowing visualization region 2A.

Refer to (II) in FIG. 8. In some feasible implementations, the liquid cooling module 10 is embedded into the display housing 25, so that the display housing 25 can have a flowing visualization region 2A.

For example, refer to FIG. 9. The liquid cooling module 10 may be embedded into a housing 20 of the vehicle-mounted device, so that the housing 20 of the vehicle-mounted device has a flowing visualization region 2A.

It should be noted that, in an implementation in which the liquid cooling module is embedded into the housing, flowing visualization regions with different shapes may be obtained by setting a shape of a light transmission region of the housing. In embodiments of this application, several shapes of the flowing visualization regions are merely described as examples, and the foregoing shapes do not constitute a specific limitation.

An embodiment of this application further discloses an accessory, applicable to an electronic device. The accessory may include an accessory body and the liquid cooling module disclosed in embodiments of this application, the liquid cooling module is embedded into the accessory body, and visible light transmittance of at least a partial region of the accessory body is greater than or equal to a threshold, so that flowing visualization effect of a working substance in the liquid cooling module can be displayed through the accessory body in the region. In other words, the region of the accessory becomes a flowing visualization region.

The following further describes the accessory with reference to specific accompanying drawings by using an example in which the accessory is a protective case.

FIG. 12 discloses a protective case. The protective case 2 may include an accessory body 40 and a liquid cooling module 10 embedded into the accessory body 40. Visible light transmittance of at least a partial region of the accessory body 40 is greater than or equal to a threshold, so that flowing visualization effect of the working substance can be displayed through the region. In other words, the accessory has a flowing display region 2A.

The accessory in this embodiment of this application may be understood as a part used together with an electronic device, and is disposed outside a housing. For example, the accessory may include but is not limited to a wrist strap and a protective case.

The following describes an application scenario of the accessory with reference to a specific example.

For example, FIG. 13 is a diagram of assembly of a wearable device 1 and a wrist strap 2 (accessory). The wrist strap 2 is connected to the wearable device 1, so that the wearable device 1 can be sleeved on a target object. A liquid cooling module may be disposed in the wrist strap, so that the wrist strap has a flowing visualization region 2A.

For example, FIG. 14 is a diagram of assembly of a tablet computer 1 and the protective case 2 (accessory). The protective case 2 may be sleeved outside the tablet computer 1, to protect the tablet computer 1. A liquid cooling module may be disposed in the protective case 2, so that the protective case 2 has a flowing visualization region 2A.

For example, FIG. 15 is a diagram of assembly of a mobile phone 1 and a connector 2 (accessory). The connector 2 is connected to the mobile phone. A liquid cooling module may be disposed in the connector 2, so that the connector 2 has a flowing visualization region 2A.

An embodiment of this application further discloses a method for preparing a working substance, including: measuring a first medium and a second medium; and mixing the first medium and the second medium to obtain the working substance. A heat dissipation coefficient of the first medium is greater than a heat dissipation coefficient of the second medium. In the working substance, a liquid-liquid interface exists between the first medium and the second medium.

The working substance, the liquid cooling module, and the electronic device provided in embodiments of this application are described in detail above. The principle and embodiments of this application are described in this specification with specific examples. The descriptions about the foregoing embodiments are merely provided to help understand the method and core ideas of this application. In addition, a person of ordinary skill in the art can make modifications to specific embodiments and application scopes based on the ideas of this application. In conclusion, the content of this specification shall not be construed as a limitation on this application.

## Claims

**1.** A working substance, comprising:

a first medium; and
a second medium, wherein a liquid-liquid interface exists between the first medium and the second medium, and a heat dissipation coefficient of the first

medium is greater than a heat dissipation coefficient of the second medium.

2. The working substance according to claim 1, further comprising a first additive, wherein the first additive is used to reduce surface tension of the first medium.

3. The working substance according to claim 2, wherein the first additive comprises at least one of a fluorocarbon surfactant, a polyoxyethylene ether nonionic surfactant, and a gemini surfactant.

4. The working substance according to claim 3, wherein a molecular structural formula of the fluorocarbon surfactant comprises:

$$F(CF_2)_xCH_2CH_2O(CH_2CH_2O)_y,$$

wherein
in $F(CF_2)_xCH_2CH_2O(CH_2CH_2O)_y$, x=6, and y ranges from 5 to 14.

5. The working substance according to claim 3, wherein a molecular structural formula of the polyoxyethylene ether nonionic surfactant comprises: at least one of $RO(CH_2CH_2O)_nH$ and

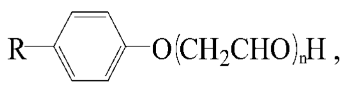

wherein R in $RO(CH_2CH_2O)_nH$ and

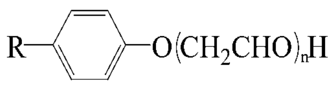

comprises a hydrophobic group or a hydrogen atom.

6. The working substance according to claim 3, wherein a molecular structural formula of the gemini surfactant comprises:

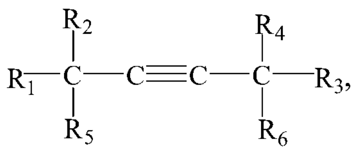

wherein
at least one of $R_1$, $R_2$, $R_3$, $R_4$, $R_5$, and $R_6$ is a hydrophilic group, and at least one of $R_1$, $R_2$, $R_3$, $R_4$, $R_5$, and $R_6$ is a hydrophobic group.

7. The working substance according to claim 6, wherein each of $R_1$, $R_2$, $R_3$, and $R_4$ comprises the hydrophobic group; and
each of $R_5$ and $R_6$ comprises the hydrophilic group.

8. The working substance according to any one of claims 2 to 7, wherein a mass fraction of the first additive in the working substance ranges from 0.01% to 20%.

9. The working substance according to any one of claims 1 to 8, further comprising a second additive, wherein the second additive is used to break an emulsion.

10. The working substance according to claim 9, wherein the second additive comprises at least one of an organic alcohol compound, an organic ketone compound, an organic acid compound, a lipid organic compound, an ether organic compound, an aromatic compound, and an organic salt.

**11.** The working substance according to claim 9, wherein a molecular structural formula of the second additive comprises:

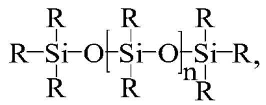

wherein R comprises at least one of methyl, methoxy, ethyl, ethoxy, propyl, butyl, pentyl, hexyl, heptyl, octyl, phenyl, hydroxyl, and vinyl, wherein a side chain of R comprises a $C_3$-$C_{18}$ alkyl substituent.

**12.** The working substance according to claim 11, wherein n in

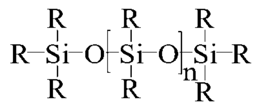

ranges from 0 to 100.

**13.** The working substance according to any one of claims 9 to 12, wherein a mass fraction of the second additive in the working substance ranges from 0.01% to 20%.

**14.** The working substance according to any one of claims 1 to 13, further comprising a water-soluble dye, wherein a solubility of the water-soluble dye in the first medium is greater than a solubility of the water-soluble dye in the second medium.

**15.** The working substance according to any one of claims 1 to 14, further comprising an oil-soluble dye, wherein a solubility of the oil-soluble dye in the second medium is greater than a solubility of the oil-soluble dye in the first medium.

**16.** The working substance according to any one of claims 1 to 15, wherein the first medium comprises at least one of water and a liquid metal.

**17.** The working substance according to any one of claims 1 to 16, wherein a mass fraction of the first medium in the working substance is greater than or equal to 50%.

**18.** The working substance according to any one of claims 1 to 17, wherein a conductivity of the first medium is less than or equal to 500 $\mu$s/cm.

**19.** The working substance according to any one of claims 1 to 18, wherein the second medium comprises at least one of hydrocarbon, a heterocyclic organic compound, and a fluorinated liquid.

**20.** The working substance according to any one of claims 1 to 19, wherein a molecular structural formula of the second medium comprises:

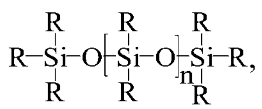

wherein R comprises at least one of methyl, methoxy, ethyl, ethoxy, propyl, butyl, pentyl, hexyl, heptyl, octyl, phenyl, hydroxyl, and vinyl.

**21.** The working substance according to any one of claims 1 to 20, wherein a mass fraction of the second medium in the working substance ranges from 0.1% to 50%.

**22.** The working substance according to any one of claims 1 to 21, wherein the working substance is used in an electronic device.

**23.** A liquid cooling module, comprising:

the working substance according to any one of claims 1 to 22; and

a pump, wherein the pump is configured to drive the working substance to move in a cavity, so that a liquid-liquid interface of the working substance moves relative to the cavity configured to accommodate the working substance.

**24.** An electronic device, comprising:

a housing and the liquid cooling module according to claim 23, wherein the liquid cooling module is embedded into the housing; and

visible light transmittance of at least a partial region of the housing covering the liquid cooling module is greater than or equal to a threshold.

**25.** The electronic device according to claim 24, wherein the housing is provided with a groove, and the groove forms a cavity configured to accommodate the working substance.

**26.** The electronic device according to claim 24, wherein the liquid cooling module further comprises a liquid cooling component, and the liquid cooling component has a cavity configured to accommodate the working substance.

**27.** An accessory, applicable to an electronic device, and comprising an accessory body and the liquid cooling module according to claim 23, wherein the liquid cooling module is embedded into the accessory body, and visible light transmittance of at least a partial region of the accessory body covering the liquid cooling module is greater than or equal to a threshold.

**28.** A method for preparing a working substance, comprising:

measuring a first medium and a second medium, wherein a heat dissipation coefficient of the first medium is greater than a heat dissipation coefficient of the second medium; and

mixing the first medium and the second medium to obtain the working substance, wherein in the working substance, a liquid-liquid interface exists between the first medium and the second medium.

[FIG. 1]

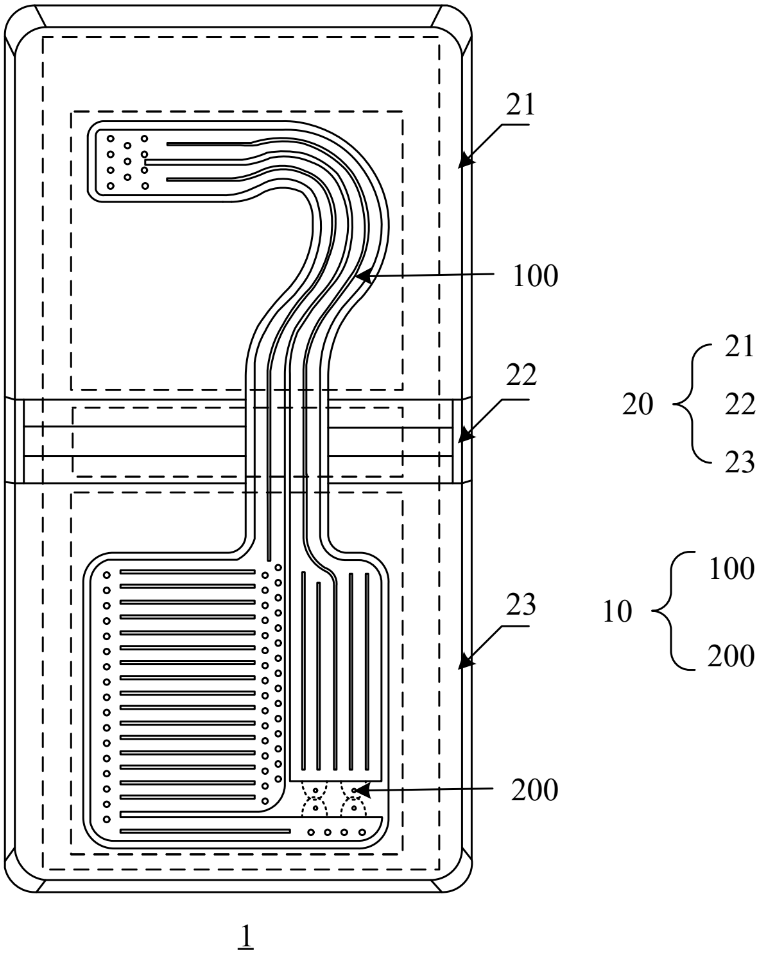

[FIG. 2]

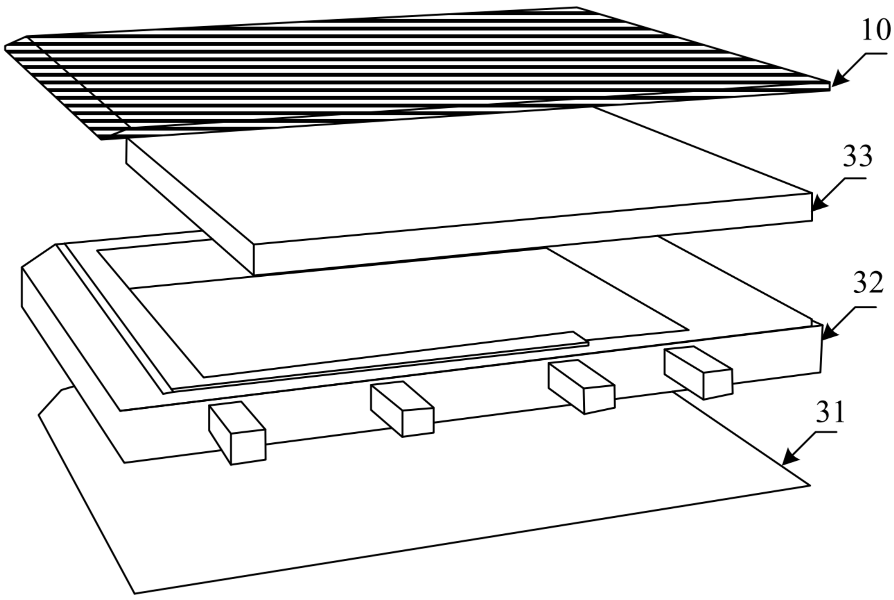


30

[FIG. 3]

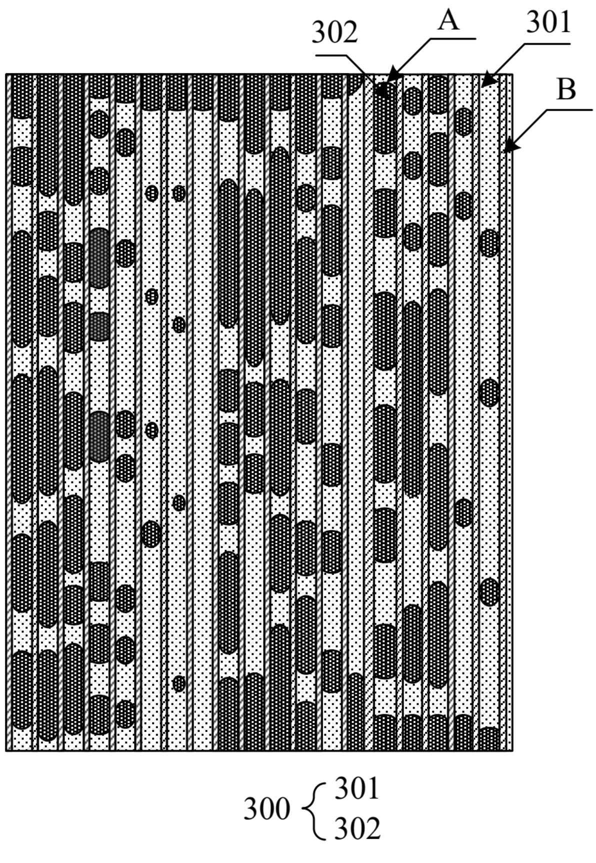

[FIG. 4]

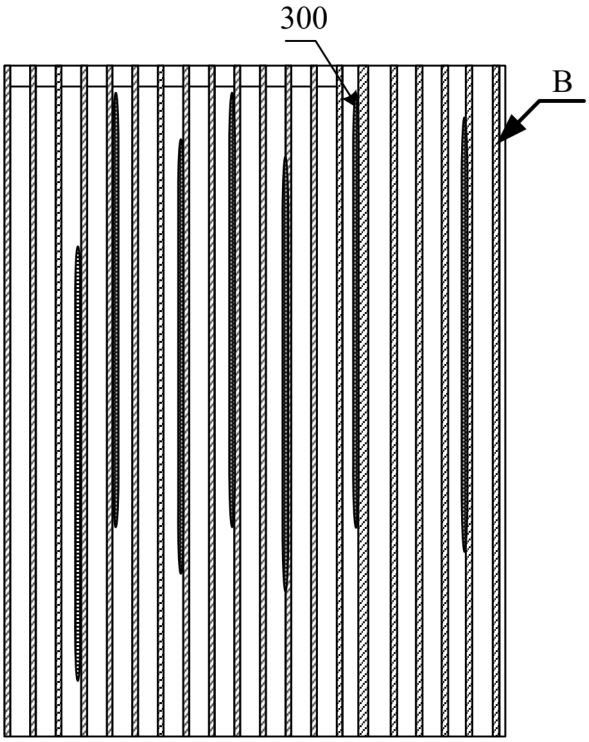


[FIG. 5]

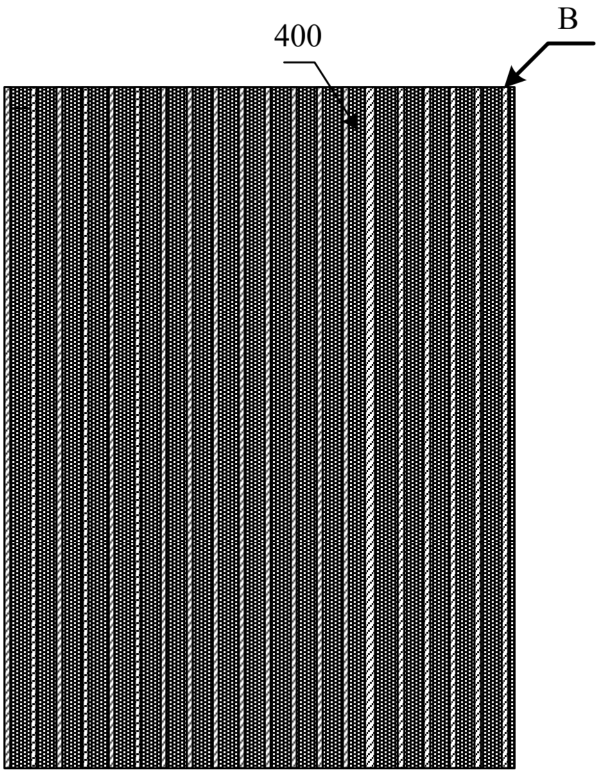

[FIG. 6]

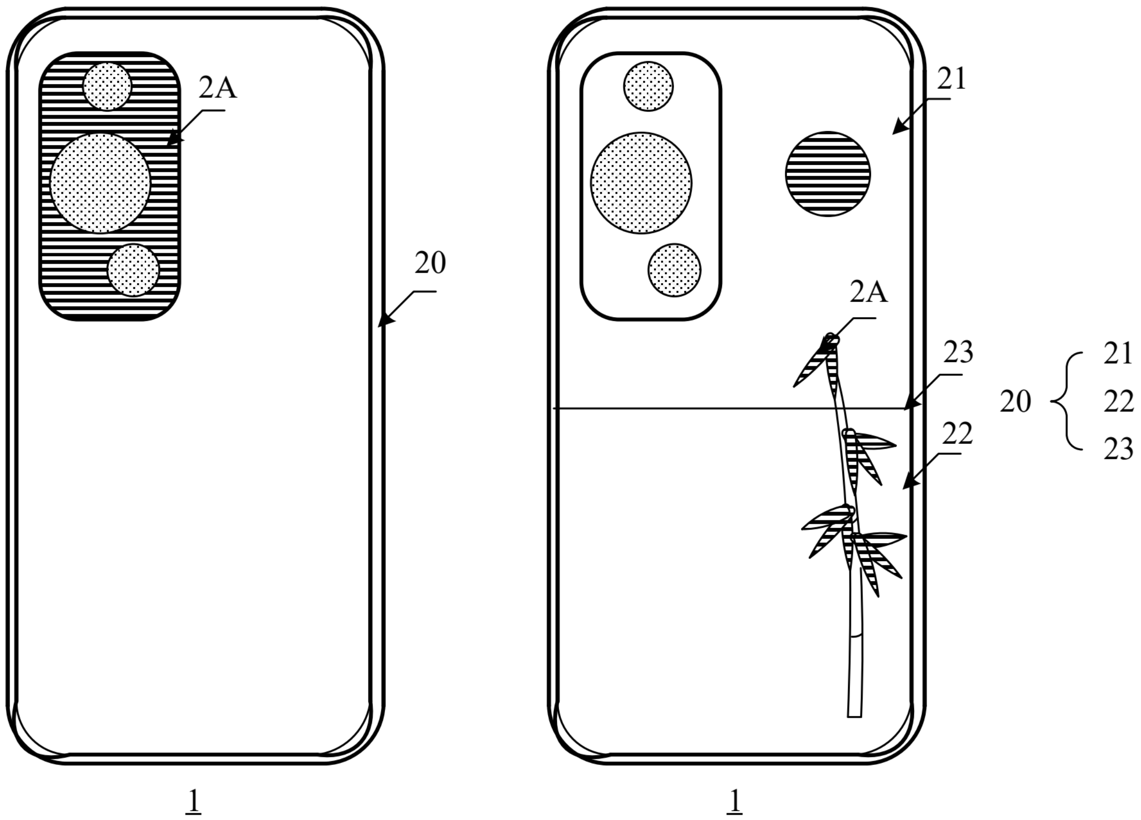


(I)

(II)

[FIG. 7]

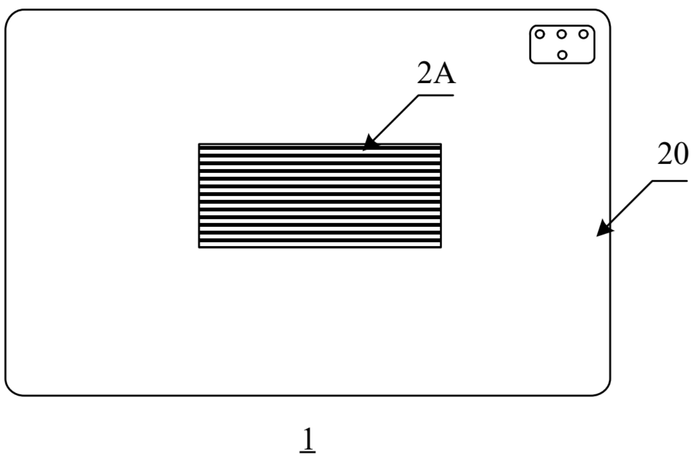

[FIG. 8]

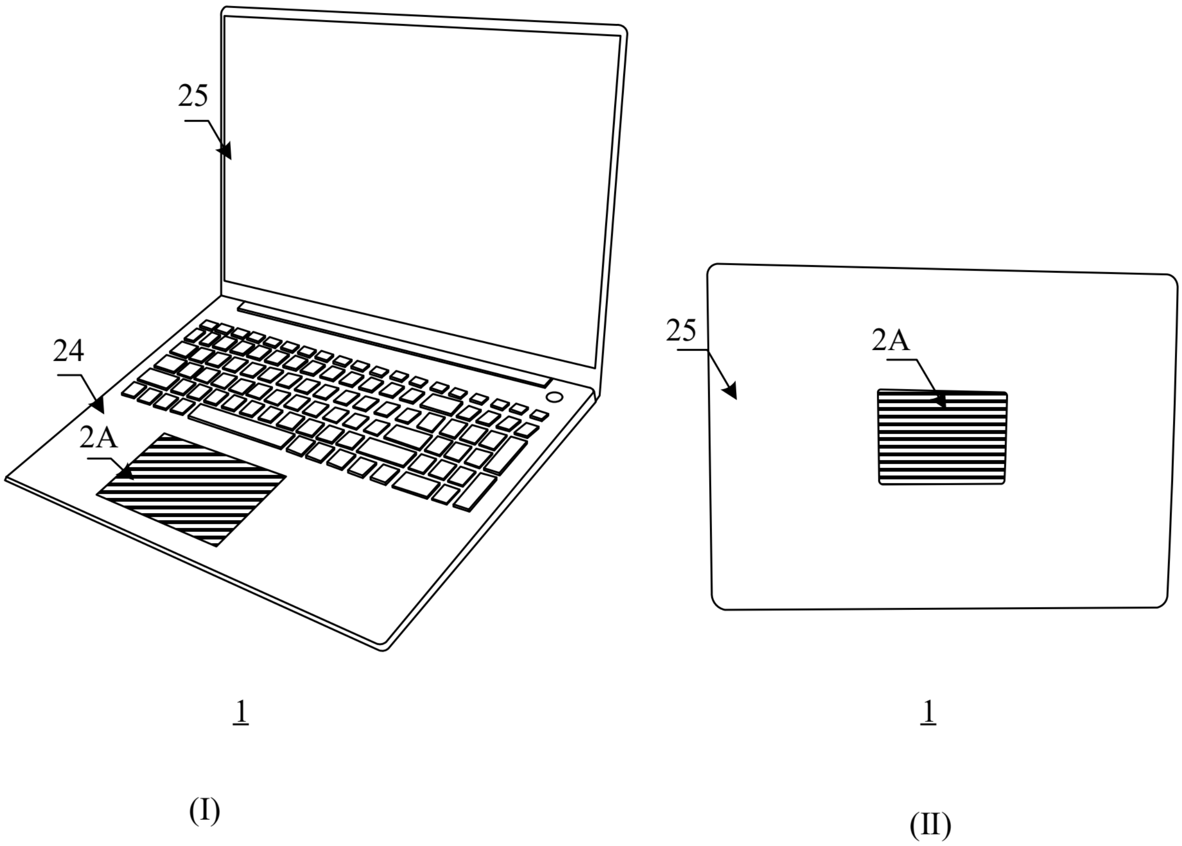


[FIG. 9]

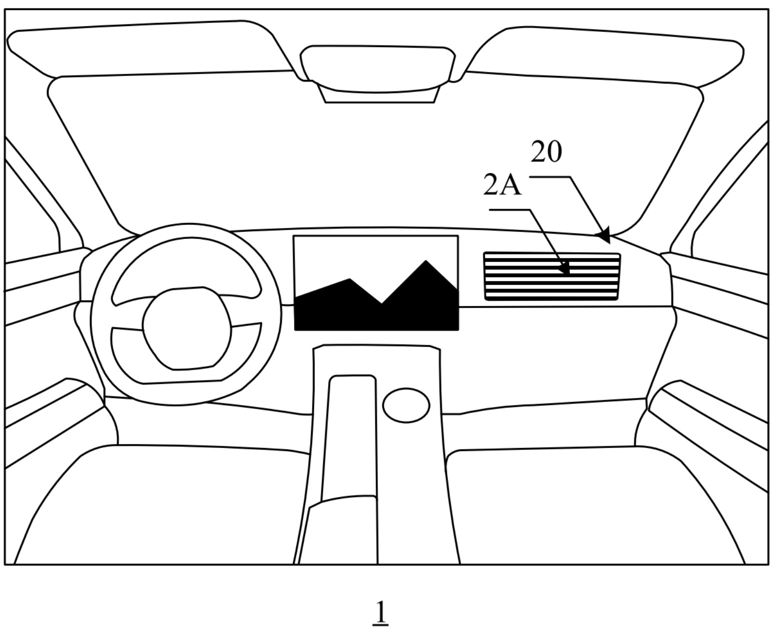

[FIG. 10]

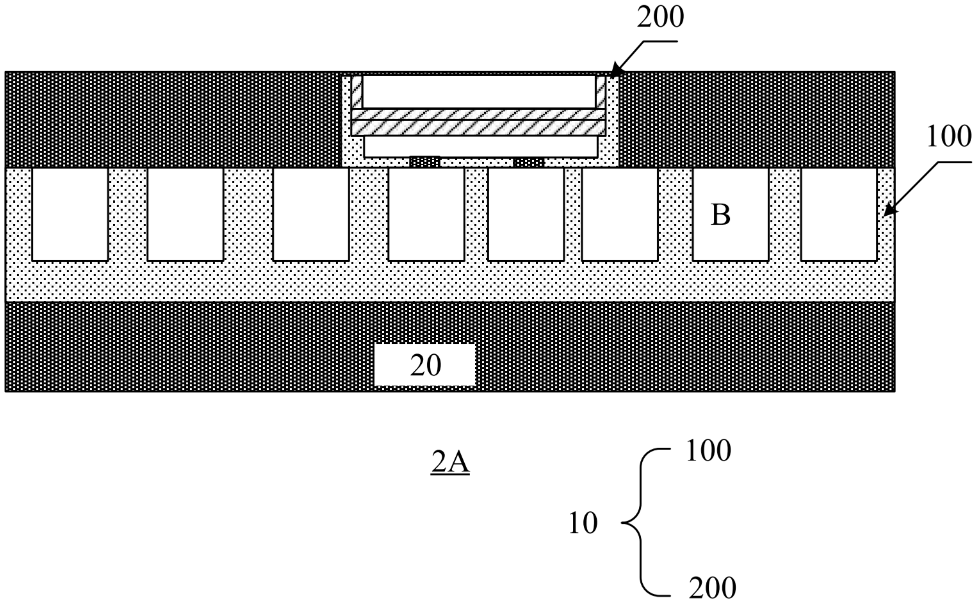


[FIG. 11]

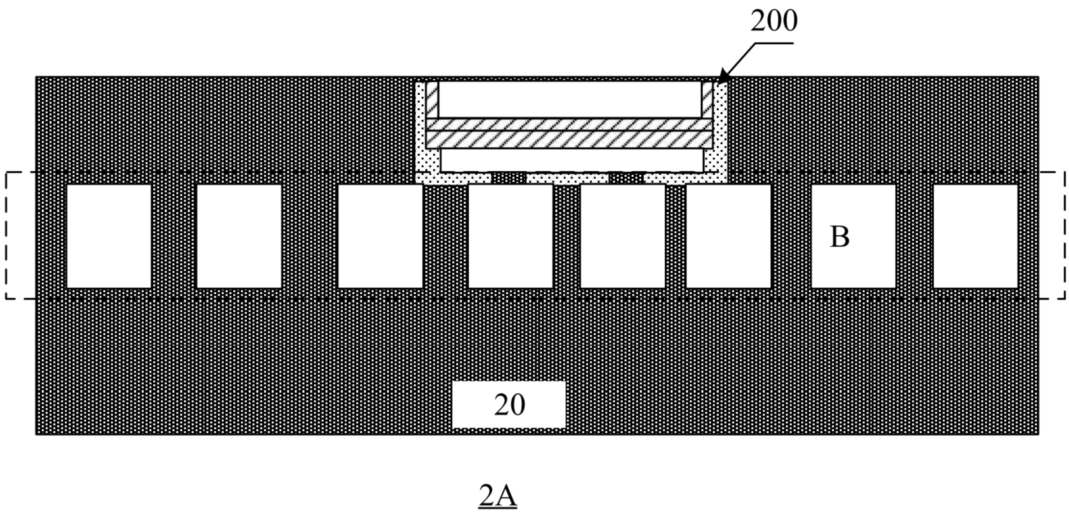

[FIG. 12]

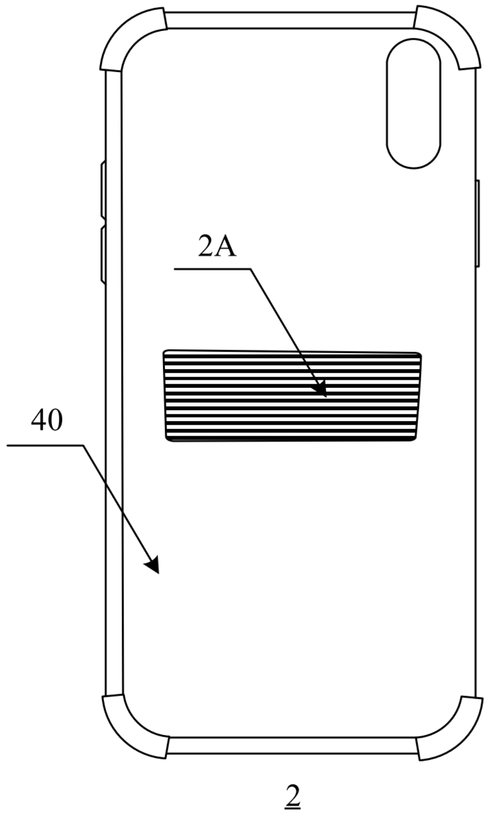


[FIG. 13]

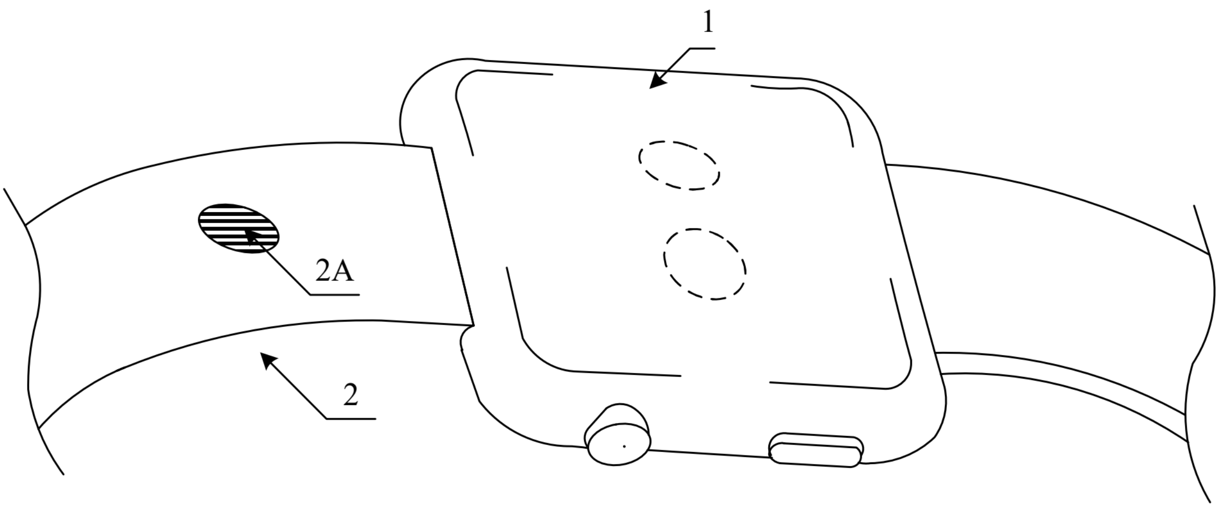

[FIG. 14]

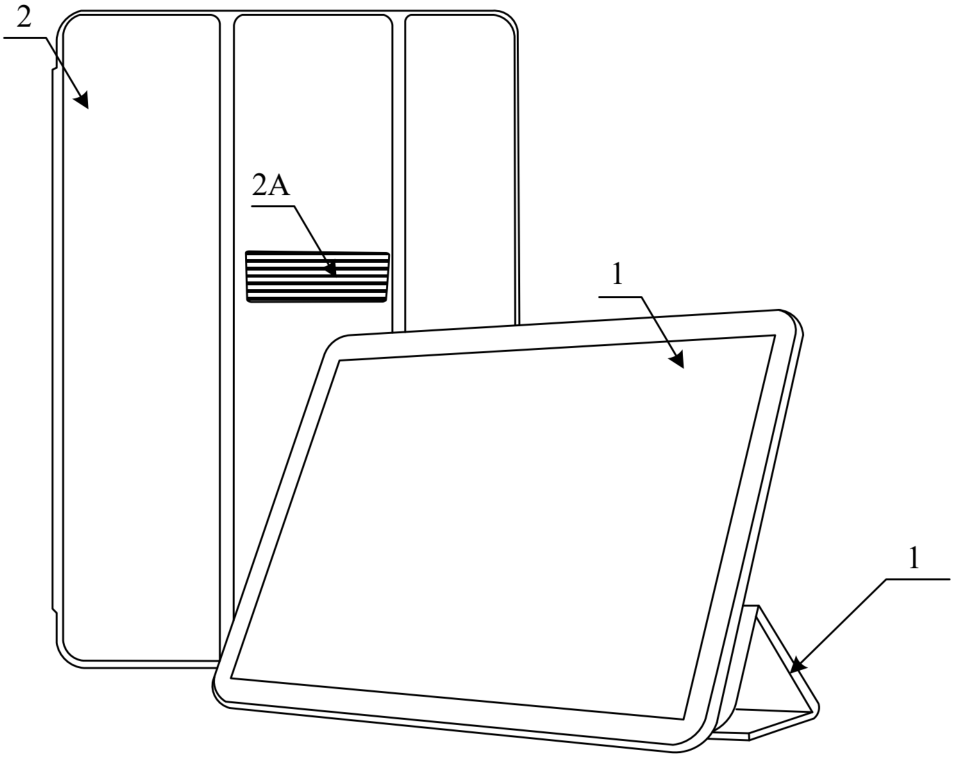


[FIG. 15]

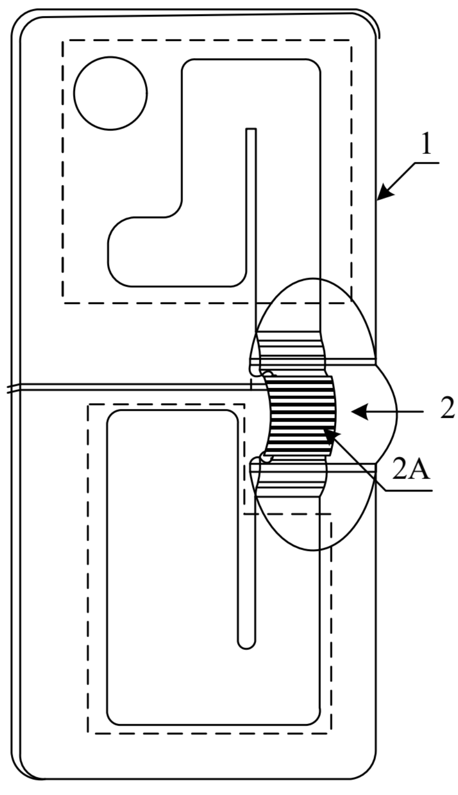

## INTERNATIONAL SEARCH REPORT

International application No.
**PCT/CN2024/096200**

**A. CLASSIFICATION OF SUBJECT MATTER**

H05K7/20(2006.01)i

According to International Patent Classification (IPC) or to both national classification and IPC

**B. FIELDS SEARCHED**

Minimum documentation searched (classification system followed by classification symbols)

IPC: H05K, H02M

Documentation searched other than minimum documentation to the extent that such documents are included in the fields searched

Electronic data base consulted during the international search (name of data base and, where practicable, search terms used)

CNTXT; WPABSC; ENTXTC; CNKI: 介质, 工质, 流动, 移动, 显色, 可视, 显示, 散热; medium, working flow, move, color, visual, display, heat

**C. DOCUMENTS CONSIDERED TO BE RELEVANT**

| Category* | Citation of document, with indication, where appropriate, of the relevant passages | Relevant to claim No. |
|---|---|---|
| PX | CN 117042386 A (HUAWEI TECHNOLOGIES CO., LTD.) 10 November 2023 (2023-11-10) claims 1-28 | 1-28 |
| X | CN 114375136 A (GUANGDONG OPPO MOBILE COMMUNICATIONS CO., LTD.) 19 April 2022 (2022-04-19) description, paragraphs [0028]-[0068], and figures 1-14 | 1, 22, 28 |
| Y | CN 114375136 A (GUANGDONG OPPO MOBILE COMMUNICATIONS CO., LTD.) 19 April 2022 (2022-04-19) description, paragraphs [0028]-[0068], and figures 1-14 | 23-27 |
| Y | CN 114554756 A (GUANGDONG OPPO MOBILE COMMUNICATIONS CO., LTD.) 27 May 2022 (2022-05-27) description, paragraphs [0023]-[0048], and figures 1-10 | 23-27 |
| A | WO 2023005807 A1 (HUAWEI TECHNOLOGIES CO., LTD.) 02 February 2023 (2023-02-02) entire document | 1-28 |

☐ Further documents are listed in the continuation of Box C.  ☑ See patent family annex.

* Special categories of cited documents:
- "A" document defining the general state of the art which is not considered to be of particular relevance
- "D" document cited by the applicant in the international application
- "E" earlier application or patent but published on or after the international filing date
- "L" document which may throw doubts on priority claim(s) or which is cited to establish the publication date of another citation or other special reason (as specified)
- "O" document referring to an oral disclosure, use, exhibition or other means
- "P" document published prior to the international filing date but later than the priority date claimed
- "T" later document published after the international filing date or priority date and not in conflict with the application but cited to understand the principle or theory underlying the invention
- "X" document of particular relevance; the claimed invention cannot be considered novel or cannot be considered to involve an inventive step when the document is taken alone
- "Y" document of particular relevance; the claimed invention cannot be considered to involve an inventive step when the document is combined with one or more other such documents, such combination being obvious to a person skilled in the art
- "&" document member of the same patent family

| Date of the actual completion of the international search | Date of mailing of the international search report |
|---|---|
| **02 July 2024** | **08 July 2024** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | Telephone No. |

Form PCT/ISA/210 (second sheet) (July 2022)

**INTERNATIONAL SEARCH REPORT**
**Information on patent family members**

International application No.
**PCT/CN2024/096200**

| Patent document cited in search report | | | Publication date (day/month/year) | Patent family member(s) | | | Publication date (day/month/year) |
|---|---|---|---|---|---|---|---|
| CN | 117042386 | A | 10 November 2023 | None | | | |
| CN | 114375136 | A | 19 April 2022 | None | | | |
| CN | 114554756 | A | 27 May 2022 | None | | | |
| WO | 2023005807 | A1 | 02 February 2023 | EP | 4355044 | A1 | 17 April 2024 |
| | | | | US | 2024164053 | A1 | 16 May 2024 |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- CN 202310631049
- CN 202410687709